# EUROPEAN PATENT APPLICATION

(11) **EP 4 664 236 A1**
(43) Date of publication of application: **17.12.2025**
(21) Application number: 24785166.0
(22) Date of filing: 02.04.2024
(51) Int. Cl.: G06F 1/16, G06F 1/18, G06F 3/041

(54) **SUPPORT LAYER AND ELECTRONIC DEVICE COMPRISING SAME**

(30) Priority: 07.04.2023 KR 20230046319; 08.06.2023 KR 20230073750
(71) Applicant: Samsung Electronics Co., Ltd., Suwon-si, Gyeonggi-do 16677 (KR)
(72) Inventor: AN, Jungchul, Suwon-si, Gyeonggi-do 16677 (KR); KIM, Sangkyu, Suwon-si, Gyeonggi-do 16677 (KR); KIM, Seonghoon, Suwon-si, Gyeonggi-do 16677 (KR); JUNG, Hyunsuk, Suwon-si, Gyeonggi-do 16677 (KR)
(74) Representative: Gulde & Partner
(86) International application number: PCT/KR2024/004244
(87) International publication number: WO 2024/210461

(57) **Abstract**

The present disclosure relates to an electronic device. An electronic device according to an embodiment of the present disclosure comprises: a first housing; a second housing coupled to be movable with respect to the first housing; a flexible display arranged in a space formed by the first housing and the second housing; a first support body spaced apart from the flexible display; a second support body which is spaced apart from the flexible display and forms a folding axis between the second support body and the first support body; a first support layer arranged between the flexible display and the first support body; and a second support layer arranged between the flexible display and the second support body, wherein the first support layer and the second support layer are spaced apart from each other with the folding axis therebetween, and have different thicknesses from each other or at least a part of the material is different from each other.

## Description

### [Technical Field]

Various embodiments of the disclosure relate to an electronic device, e.g., a support layer and an electronic device including the same.

### [Background Art]

Advancing information communication and semiconductor technologies accelerate the spread and use of various electronic devices. In particular, recent electronic devices are being developed to carry out communication while carried on.

The term "electronic device" may mean a device performing a particular function according to its equipped program, such as a home appliance, an electronic scheduler, a portable multimedia player, a mobile communication terminal, a tablet PC, a video/sound device, a desktop PC or laptop computer, a navigation for automobile, etc. For example, the electronic devices may output stored information as voices or images. As electronic devices are highly integrated, and high-speed, high-volume wireless communication becomes commonplace, an electronic device, such as a mobile communication terminal, is recently being equipped with various functions. For example, an electronic device comes with the integrated functionality, including an entertainment function, such as playing video games, a multimedia function, such as playing music/videos, a communication and security function, such as for mobile banking, and a scheduling or e-wallet function. These electronic devices have been downsized to be conveniently carried by users.

### [Detailed Description of the Invention]

### [Technical Solution]

According to an embodiment, an electronic device comprises a first housing, a second housing movably coupled to the first housing, a flexible display disposed in a space formed by the first housing and the second housing, a first support body spaced apart from the flexible display, a second support body spaced apart from the flexible display and forming a folding axis between the first support body and the second support body, a first support layer disposed between the flexible display and the first support body, and a second support layer disposed between the flexible display and the second support body. The first support layer and the second support layer are spaced apart from each other with the folding axis disposed therebetween, and have different thicknesses or at least partially have different materials.

According to an embodiment, an electronic device comprises a flexible display, a support body spaced apart from the flexible display, a support layer including a conductive layer disposed between the flexible display and the support body, and a reinforcement layer disposed between the conductive layer and the support body, a digitizer disposed between the flexible display and the support layer, a digitizer connection circuit disposed between the support layer and the support body and electrically connected to the digitizer, and a ground member connecting the digitizer connection circuit and the conductive layer of the support layer and penetrating at least a portion of the support layer.

According to an embodiment, an electronic device comprises a first housing, a second housing movably coupled to the first housing, a flexible display disposed in a space formed by the first housing and the second housing, a first support body spaced apart from the flexible display, a second support body spaced apart from the flexible display and forming a folding axis between the first support body and the second support body, a first support layer disposed between the flexible display and the first support body, and a second support layer disposed between the flexible display and the second support body. The first support layer and the second support layer are spaced apart from each other with the folding axis disposed therebetween and have different thicknesses.

### [Brief Description of Drawings]

FIG. 1 is a block diagram illustrating an electronic device in a network environment according to an embodiment;
FIG. 2 is a view illustrating an unfolded state of an electronic device according to an embodiment of the disclosure;
FIG. 3 is a view illustrating a folded state of an electronic device according to an embodiment of the disclosure;
FIG. 4 is an exploded perspective view illustrating an electronic device according to an embodiment of the disclosure;
FIG. 5A illustrates a portion of an electronic device according to an embodiment of the disclosure;
FIG. 5B illustrates a portion of an electronic device according to an embodiment of the disclosure;
FIG. 6A illustrates a portion of an electronic device according to an embodiment of the disclosure;
FIG. 6B is a cross-sectional view taken along line P-P' illustrated in FIG. 6A;
FIG. 6C is a cross-sectional view taken along line Q-Q' illustrated in FIG. 6A;
FIG. 6D is a cross-sectional view taken along line R-R' illustrated in FIG. 6A;
FIG. 7A illustrates a portion of an electronic device according to an embodiment of the disclosure;
FIG. 7B illustrates a portion of an electronic device according to an embodiment of the disclosure;
FIG. 7C illustrates a portion of an electronic device according to an embodiment of the disclosure;
FIG. 7D illustrates a portion of an electronic device according to an embodiment of the disclosure;
FIG. 8 is a diagram conceptually illustrating an operation according to an embodiment of the disclosure;
FIG. 9A illustrates a portion of an electronic device according to an embodiment of the disclosure;
FIG. 9B illustrates a portion of an electronic device according to an embodiment of the disclosure;
FIG. 10 illustrates a portion of an electronic device according to an embodiment of the disclosure;
FIG. 11 illustrates a portion of an electronic device according to an embodiment of the disclosure;
FIG. 12A illustrates a portion of an electronic device in an unfolded state according to an embodiment of the disclosure;
FIG. 12B illustrates a portion of an electronic device in a folded state according to an embodiment of the disclosure; and
FIG. 13 illustrates a portion of an electronic device according to an embodiment of the disclosure.

### [Mode for Carrying out the Invention]

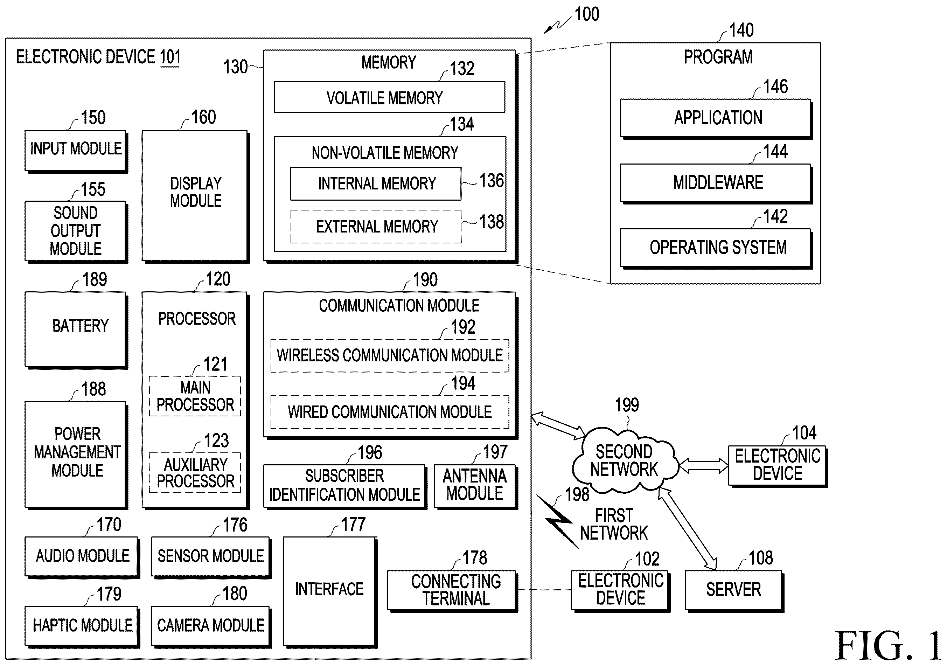

FIG. 1 is a block diagram illustrating an electronic device 101 in a network environment 100 according to various embodiments.

Referring to FIG. 1, the electronic device 101 in the network environment 100 may communicate with at least one of an electronic device 102 via a first network 198 (e.g., a short-range wireless communication network), or an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module (SIM) 196, or an antenna module 197. In an embodiment, at least one (e.g., the connecting terminal 178) of the components may be omitted from the electronic device 101, or one or more other components may be added in the electronic device 101. According to an embodiment, some (e.g., the sensor module 176, the camera module 180, or the antenna module 197) of the components may be integrated into a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to an embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the sub processor 123, the sub processor 123 may be configured to use lower power than the main processor 121 or to be specified for a designated function. The sub processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. The artificial intelligence model may be generated via machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted Boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by other component (e.g., the processor 120) of the electronic device 101, from the outside (e.g., a user) of the electronic device 101. The input module 150 may include, for example, a microphone, a mouse, a keyboard, keys (e.g., buttons), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display 160 may include, for example, a display, a hologram device, or a projector and control circuitry to control a corresponding one of the display, hologram device, and projector. According to an embodiment, the display 160 may include a touch sensor configured to detect a touch, or a pressure sensor configured to measure the intensity of a force generated by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operation state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an accelerometer, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, an HDMI connector, a USB connector, an SD card connector, or an audio connector (e.g., a headphone connector).

The haptic module 179 may convert an electrical signal into a mechanical stimulus (e.g., a vibration or motion) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to an embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device 104 via a first network 198 (e.g., a short-range communication network, such as Bluetooth^{™}, wireless-fidelity (Wi-Fi) direct, or infrared data association (IrDA)) or a second network 199 (e.g., a long-range communication network, such as a legacy cellular network, a 5G network, a next-generation communication network, the Internet, or a computer network (e.g., local area network (LAN) or wide area network (WAN)). These various types of communication modules may be implemented as a single component (e.g., a single chip), or may be implemented as multi components (e.g., multi chips) separate from each other. The wireless communication module 192 may identify or authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device). According to an embodiment, the antenna module 197 may include one antenna including a radiator formed of a conductor or conductive pattern formed on a substrate (e.g., a printed circuit board (PCB)). According to an embodiment, the antenna module 197 may include a plurality of antennas (e.g., an antenna array). In this case, at least one antenna appropriate for a communication scheme used in a communication network, such as the first network 198 or the second network 199, may be selected from the plurality of antennas by, e.g., the communication module 190. The signal or the power may then be transmitted or received between the communication module 190 and the external electronic device via the selected at least one antenna. According to an embodiment, other parts (e.g., radio frequency integrated circuit (RFIC)) than the radiator may be further formed as part of the antenna module 197.

According to various embodiments, the antenna module 197 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. The external electronic devices 102 or 104 each may be a device of the same or a different type from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an Internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

The electronic device according to various embodiments of the disclosure may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wiredly), wirelessly, or via a third element.

As used herein, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The storage medium readable by the machine may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to various embodiments of the disclosure may be included and provided in a computer program product. The computer program products may be traded as commodities between sellers and buyers. The computer program product may be distributed in the form of a machine-readable storage medium (e.g., compact disc read only memory (CD-ROM)), or be distributed (e.g., downloaded or uploaded) online via an application store (e.g., Play Store^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities. Some of the plurality of entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

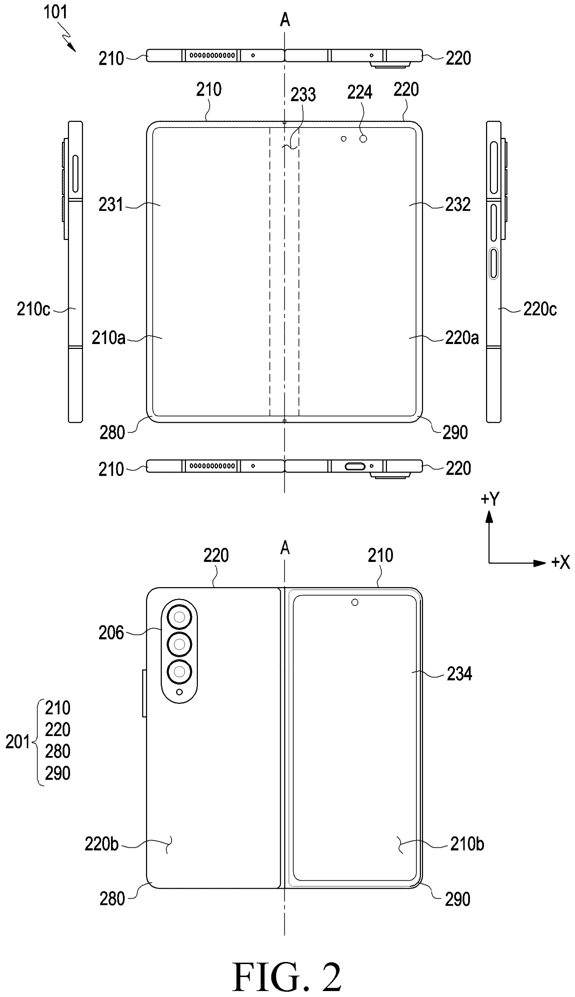

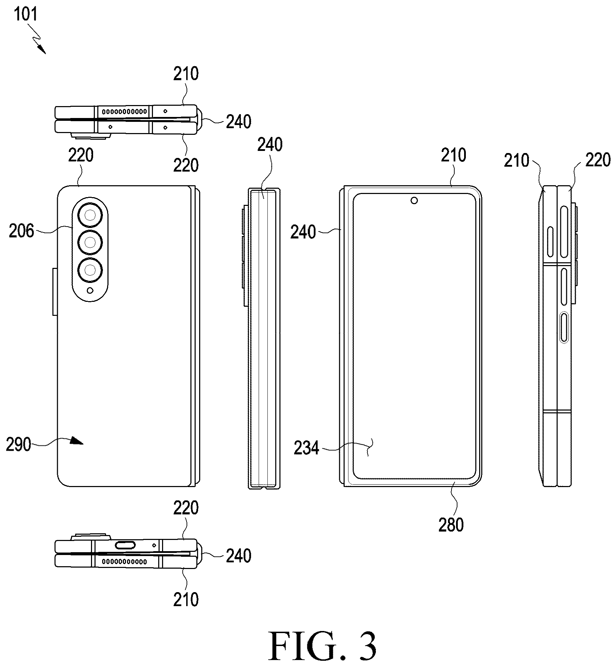

FIG. 2 is a view illustrating an unfolded state of an electronic device according to an embodiment of the disclosure. FIG. 3 is a view illustrating a folded state of an electronic device according to an embodiment of the disclosure.

Referring to FIGS. 2 and 3, an electronic device 101 may include a housing 201, a hinge cover 240 covering a foldable portion of the housing 201, and a display 230 disposed in a space formed by the housing 201. According to an embodiment, the surface where the screen output from the display 230 is exposed is defined as a front surface (e.g., the first front surface 210a and the second front surface 220a) of the electronic device 101. A surface opposite to the front surface is defined as a rear surface (e.g., the first rear surface 210b and the second rear surface 220b) of the electronic device 101. Further, a surface surrounding the space between the front surface and the rear surface is defined as a side surface (e.g., the first side surface 210c and the second side surface 220c) of the electronic device 101. The side surface of the electronic device 101 may be a side surface of at least one of the first housing 210 or the second housing 220. The electronic device 101 of FIGS. 2 and 3 may be referred to as a foldable electronic device, a portable electronic device, or a portable foldable electronic device. According to an embodiment, the housing 201 may be referred to as a foldable housing. The display 230 may be referred to as a "flexible display."

According to an embodiment, the housing 201 may include a first housing 210, a second housing 220 rotatable with respect to the first housing 210, a first rear cover 280, and a second rear cover 290. The housing 201 of the electronic device 101 are not limited to the shape and coupling shown in FIGS. 2 and 3 but may rather be implemented in other shapes or via a combination and/or coupling of other components. For example, in an embodiment, the first housing 210 and the first rear cover 280 may be integrally formed with each other, and the second housing 220 and the second rear cover 290 may be integrally formed with each other.

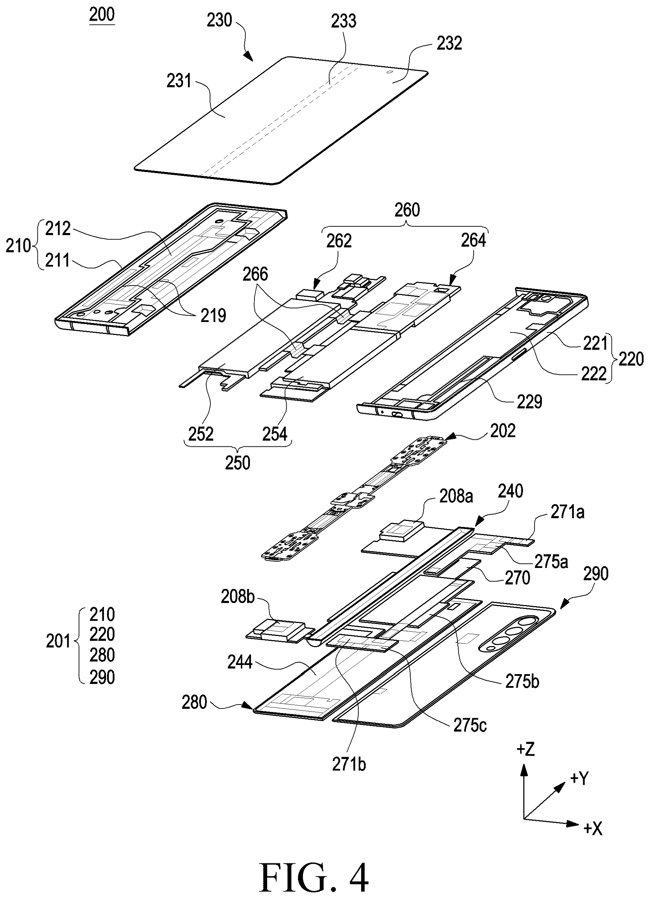

According to an embodiment, the first housing 210 may be connected to a hinge structure (e.g., the hinge assembly 202 of FIG. 4) and may include a first front surface 210a facing in a first direction and a first rear surface 210b facing in a second direction opposite to the first direction. The second housing 220 may be connected to the hinge assembly 202 and may include a second front surface 220a facing in a third direction and a second rear surface 220b facing in a fourth direction opposite to the third direction, and may rotate from the first housing 210 about the hinge assembly 202. Accordingly, the electronic device 101 may be changed to a folded state or an unfolded state. In the folded state of the electronic device 101, the first front surface 210a may face the second front surface 220a and, in the unfolded state, the third direction may be identical to the first direction. Hereinafter, unless otherwise mentioned, directions are described based on the unfolded state of the electronic device 101.

According to an embodiment, the first housing 210 and the second housing 220 are disposed on both sides of the folding axis A and be overall symmetrical in shape with respect to the folding axis A. As set forth below, the first housing 210 and the second housing 220 may have different angles or distances formed therebetween depending on whether the electronic device 101 is in the unfolded, folded, or intermediate state. According to an embodiment, the second housing 220 further includes the sensor area 224 where sensors (e.g., front camera) are disposed but, in the remaining area, the second housing 220 may be symmetrical in shape with the first housing 210.

According to an embodiment, there may be provided a plurality of (e.g., two) folding axes A parallel to each other. In the disclosure, the folding axis A is provided along the length direction (Y-axis direction) of the electronic device 101, but the direction of the folding axis A is not limited thereto. For example (not shown), the electronic device 101 may include the folding axis A extending along the width direction (e.g., X-axis direction).

According to an embodiment, the electronic device 101 may include a structure to which a digital pen may be attached. For example, the electronic device 101 may include a magnetic substance configured to attach the digital pen to a side surface of the first housing 210 or a side surface of the second housing 220. According to an embodiment, the electronic device 101 may include a structure into which a digital pen may be inserted. For example, a hole (not shown) into which the digital pen may be inserted may be formed in a side surface of the first housing 210 or a side surface of the second housing 220 of the electronic device 101.

According to an embodiment, the first housing 210 and the second housing 220 may at least partially be formed of a metal or non-metallic material with a rigidity selected to support the display 230. At least a portion formed of metal may provide a ground plane of the electronic device 101 and may be electrically connected with a ground line formed on a printed circuit board (e.g., the circuit board 260 of FIG. 4).

According to an embodiments, the sensor area 224 may be formed adjacent to an edge or corner of the second housing 220 and to have a predetermined area. However, the placement, shape, or size of the sensor area 224 is not limited to those illustrated. For example, in another embodiment, the sensor area 224 may be provided in a different corner of the second housing 220 or in any area between the top corner and the bottom corner or in the first housing 210. In an embodiment, components for performing various functions, embedded in the electronic device 101, may be exposed through the sensor area 224 or one or more openings in the sensor area 224 to the front surface of the electronic device 101. In various embodiments, the components may include various kinds of sensors. The sensor may include, e.g., at least one of a front camera, a receiver, or a proximity sensor.

According to an embodiment, the first rear cover 280 may be disposed on one side of the folding axis A on the rear surface of the electronic device 101 and have, e.g., a substantially rectangular periphery which may be surrounded by the first housing 210. Similarly, the second rear cover 290 may be disposed on the opposite side of the folding axis A on the rear surface of the electronic device 101 and its periphery may be surrounded by the second housing 220.

According to an embodiment, the first rear cover 280 and the second rear cover 290 may be substantially symmetrical in shape with respect to the folding axis (axis A). However, the first rear cover 280 and the second rear cover 290 are not necessarily symmetrical in shape. In another embodiment, the electronic device 101 may include the first rear cover 280 and the second rear cover 290 in various shapes.

According to an embodiment, the first rear cover 280, the second rear cover 290, the first housing 210, and the second housing 220 may form a space where various components (e.g., a printed circuit board or battery) of the electronic device 101 may be disposed. According to an embodiment, one or more components may be arranged or visually exposed on/through the rear surface of the electronic device 101. For example, at least a portion of a sub display (e.g., the sub display 244 of FIG. 4) may be visually exposed through at least a portion of the first rear cover 280. In another embodiment, one or more components or sensors may be visually exposed through at least a portion of the first rear cover 290. According to various embodiments, the sensor may include a proximity sensor and/or a camera module 206 (e.g., rear camera).

According to an embodiment, a front camera exposed to the front surface of the electronic device 101 through one or more openings provided in the sensor area 224 or the camera module 206 exposed through at least a portion of the second rear cover 290 may include one or more lenses, an image sensor, and/or an image signal processor. In an embodiment, two or more lenses (infrared camera, wide-angle and telephoto lens) and image sensors may be disposed on one surface of the electronic device 101.

According to an embodiment, the hinge cover 240 may be disposed between the first housing 210 and the second housing 220 to hide the internal components (e.g., the hinge assembly 202 of FIG. 4). According to an embodiment, the hinge cover 240 may be hidden by a portion of the first housing 210 and second housing 220 or be exposed to the outside depending on the state (e.g., the unfolded state (e.g., flat state) or folded state) of the electronic device 101.

According to an embodiment, as shown in FIG. 2, in the unfolded state of the electronic device 101, the hinge cover 240 may be hidden, and thus not exposed, by the first housing 210 and the second housing 220. As another example, as shown in FIG. 3, in the folded state (e.g., a fully folded state) of the electronic device 101, the hinge cover 240 may be exposed to the outside between the first housing 210 and the second housing 220. As another example, in an intermediate state in which the first housing 210 and the second housing 220 are folded with a certain angle, the hinge cover 240 may be partially exposed to the outside between the first housing 210 and the second housing 220. However, in this case, the exposed area may be smaller than that in the completely folded state. In an embodiment, the hinge cover 240 may include a curved surface.

According to an embodiment, the display 230 may be disposed in a space formed by the housing 201. For example, the display 230 may be seated on a recess formed by the housing 201 and may occupy most of the front surface of the electronic device 101. Thus, the front surface of the electronic device 101 may include the display 230 and a partial area of the first housing 210 and a partial area of the second housing 220, which are adjacent to the display 230. The rear surface of the electronic device 101 may include a first rear cover 280, a partial area of the first housing 210 adjacent to the first rear cover 280, a second rear cover 290, and a partial area of the second housing 220 adjacent to the second rear cover 290.

According to an embodiment, the display 230 may include a plurality of displays spaced apart from each other. For example, the display 230 may include a first display area 231 disposed on the first housing 210 and a second display area 232 disposed on the second housing 220. According to an embodiment, the first display area 231 and the second display area 232 may rotate about the folding axis A.

According to an embodiment, the display 230 may mean a display at least a portion of which may be transformed into a flat or curved surface. For example, the display 230 may be a foldable or flexible display. According to an embodiment, the display 230 may include a folding area 233, a first display area 231 disposed on one side of the folding area 233 (e.g., the left side of the folding area 233 of FIG. 2), and a second display area 232 disposed on the opposite side of the folding area 233 (e.g., the right side of the folding area 203 of FIG. 2). However, the segmentation of the display 230 is merely an example, and the display 230 may be divided into a plurality of (e.g., four or more, or two) areas depending on the structure or function of the display 200. For example, in the embodiment illustrated in FIG. 2, the display 230 may be divided into the areas by the folding area 233 or folding axis (axis A) extending in parallel with the Y axis but, in another embodiment, the display 230 may be divided into the areas with respect to another folding area (e.g., a folding area parallel with the X axis) or another folding axis (e.g., a folding axis parallel with the X axis). According to an embodiment, the display 230 may be coupled with or disposed adjacent to a touch detection circuit, a pressure sensor capable of measuring the strength (pressure) of touches, and/or a digitizer (not shown) for detecting a magnetic field-type stylus pen.

According to an embodiment, the first display area 231 and the second display area 232 may be overall symmetrical in shape with respect to the folding area 233. According to an embodiment (not shown), unlike the first display area 231, the second display area 232 may include a notch depending on the presence of the sensor area 224, but the rest may be symmetrical in shape with the first display area 231. In other words, the first display area 231 and the second display area 232 may include symmetrical portions and asymmetrical portions.

Described below are the operation of the first housing 210 and the second housing 220 and each area of the display 230 depending on the state (e.g., the unfolded state (or flat state) and folded state) of the electronic device 101.

According to an embodiment, when the electronic device 101 is in the unfolded state (flat state) (e.g., FIG. 2), the first housing 210 and the second housing 220 may be disposed to face in the same direction while being angled substantially at 180 degrees therebetween. The surface of the first display area 231 and the surface of the second display area 232 of the display 230 may be angled at 180 degrees therebetween while facing in the same direction (e.g., forward of the front surface of the electronic device). The folding area 233 may form the same plane with the first display area 231 and the second display area 232.

According to an embodiment, when the electronic device 101 is in the folded state (e.g., FIG. 3), the first housing 210 and the second housing 220 may be disposed to face each other. The surface of the first display area 231 and the surface of the second display area 232 of the display 230 may be angled at a small angle (e.g., an angle between 0 degrees and 10 degrees) therefrom while facing each other. At least a portion of the folding area 233 may be formed as a curve having a predetermined curvature.

According to an embodiment, when the electronic device 101 is in the intermediate state (not shown), the first housing 210 and the second housing 220 may be disposed at a certain angle therebetween. The surface of the first display area 231 of the display 230 and the surface of the second display area 232 may form an angle which is larger than the angle in the folded state and smaller than the angle in the unfolded state. The folding area 233 may at least partially have a curved surface with a predetermined curvature and, in this case, the curvature may be smaller than that when it is in the folded state.

FIG. 4 is an exploded perspective view illustrating an electronic device according to an embodiment of the disclosure.

Referring to FIG. 4, an electronic device 101 may include a housing 201, a display 230, a hinge assembly 202, a battery 250, and a board unit 260. The housing 201 may include a first housing 210, a second housing 220, a first rear cover 280, and a second rear cover 290. The configuration of the first housing 210, the second housing 220, the hinge cover 240, the first rear cover 280, and the second rear cover 290 of FIG. 4 may be identical in whole or part to the configuration of the first housing 210, the second housing 220, the hinge cover 240, the first rear cover 280, and the second rear cover 290 of FIG. 2 and/or FIG. 3.

According to an embodiment, the first housing 210 and the second housing 220 may be assembled together to be coupled to two opposite sides of the hinge assembly 202. According to an embodiment, the first housing 210 may include a first supporting area 212 that may support the components (e.g., the first circuit board 262 and/or the first battery 252) of the electronic device 101 and a first sidewall 211 surrounding at least a portion of the first supporting area 212. The first sidewall 211 may include a first side surface (e.g., the first side surface 210c of FIG. 2) of the electronic device 101. According to an embodiment, the second housing 220 may include a second supporting area 222 that may support the components (e.g., the second circuit board 264 and/or the second battery 254) of the electronic device 101 and a second sidewall 221 surrounding at least a portion of the second supporting area 222. The second sidewall 221 may include a second side surface (e.g., the second side surface 220c of FIG. 2) of the electronic device 101.

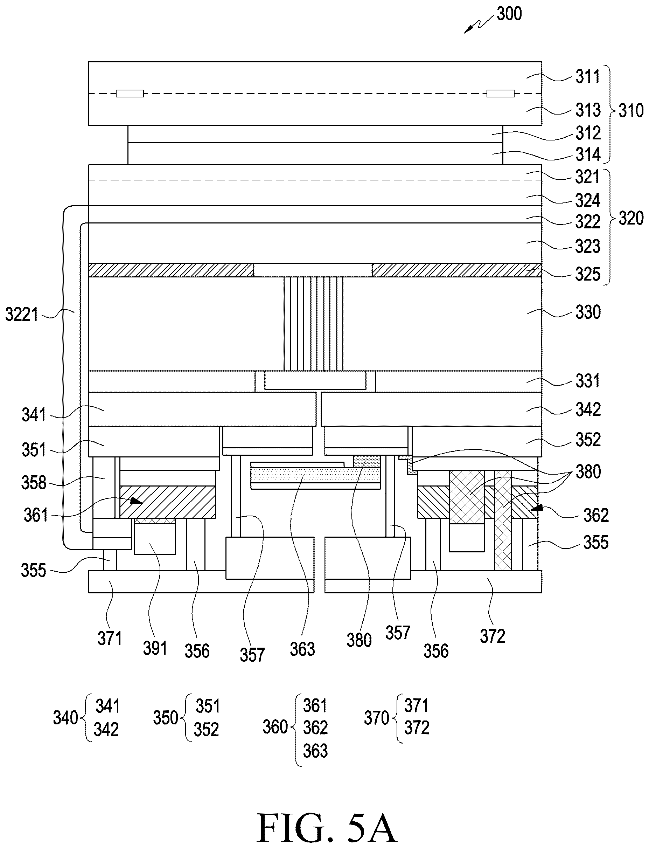

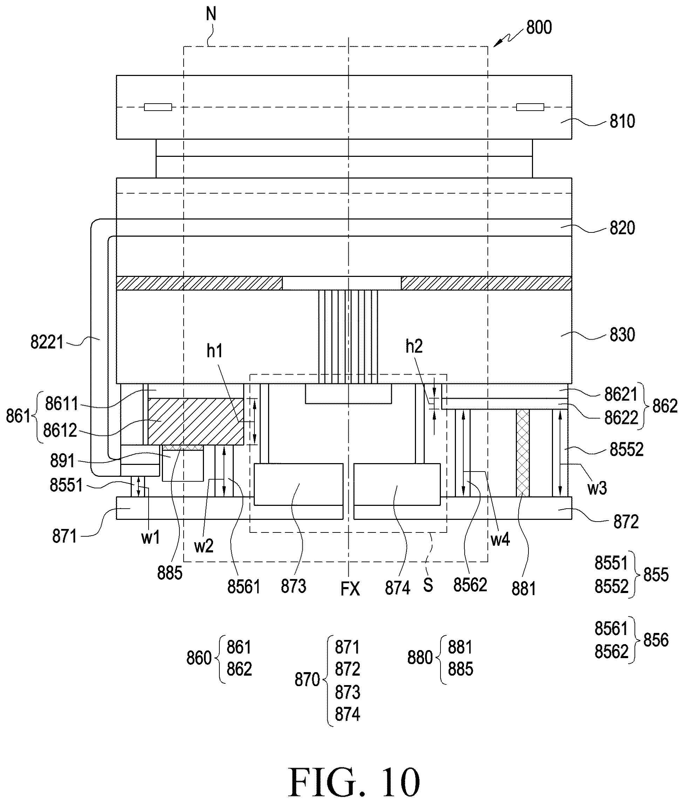

According to an embodiment, the first housing 210 may include a first waterproofing member 219. The second housing 220 may include a second waterproofing member 229. The first waterproofing member 219 may be disposed in the first support area 212. The second waterproofing member 229 may be disposed in the second support area 222. The first waterproofing member 219 may be identical, in part or in whole, to the waterproofing members 355 and 356 of FIG. 5A. The first waterproofing member 219 may be identical, in part or in whole, to the waterproofing members 8551 and 8561 of FIGS. 10 to 12B. The second waterproofing member 229 may be identical, in part or in whole, to the waterproofing members 355 and 356 of FIG. 5A. The second waterproofing member 229 may be identical, in part or in whole, to the waterproofing members 8552 and 8562 of FIGS. 10 to 12B.

According to an embodiment, the display 230 may include a first display area 231, a second display area 232, a folding area 233, and a sub display 244. The configuration of the first display area 231, the second display area 232, and the folding area 233 of FIG. 3 may be identical in whole or part to the configuration of the first display area 231, the second display area 232, and the folding area 233 of FIG. 1 and/or FIG. 2.

According to an embodiment, the sub display 244 may display screen in a different direction from the display areas 231 and 232. For example, the sub display 234 may output screen in a direction opposite to the first display area 231. According to an embodiment, the sub display 234 may be disposed on the first rear cover 280.

According to an embodiment, the battery 250 may include a first battery 252 disposed in the first housing 210 and a second battery 254 disposed in the second housing 220. According to an embodiment, the first battery 252 may be connected with the first circuit board 262, and the second battery 254 may be connected to the second circuit board 264. According to an embodiment, the battery 250 may supply power to at least one component of the electronic device 101. According to an embodiment, the battery 250 may include, e.g., a non-rechargeable primary battery, a rechargeable secondary battery, or a fuel cell.

According to an embodiment, the board unit 260 may include a first circuit board 262 disposed in the first housing 210 and a second circuit board 264 disposed in the second housing 220. According to an embodiment, the first circuit board 262 and the second circuit board 264 may be electrically connected by at least one flexible circuit board 266. According to an embodiment, at least a portion of the flexible circuit board 266 may be disposed across the hinge assembly 202. According to an embodiment, the first circuit board 262 and the second circuit board 264 may be disposed in a space formed by the first housing 210, the second housing 220, the first rear cover 280, and the second rear cover 290. Components for implementing various functions of the electronic device 101 may be disposed on the first circuit board 262 and the second circuit board 264.

According to an embodiment, the electronic device 101 may include speakers 208a and 208b. According to an embodiment, the speakers 208a and 2008b may convert the electric signal into sound. According to an embodiment, the speakers 208 and 208b may be disposed in a space formed by the first housing 210, the second housing 220, the first rear cover 280, and the second rear cover 290. According to an embodiment, the speakers 208a and 208b may include an upper speaker 208a positioned in an upper portion (+Y direction) of the electronic device 101 and a lower speaker 208b positioned in a lower portion (-Y direction) of the electronic device 101. In the disclosure, the speakers 208a and 208b are illustrated as positioned in one housing (e.g., the first housing 210 of FIG. 40, but this is an optional structure. For example, the speakers 208a and 208b may be positioned in at least one of the first housing 210 or the second housing 220. The configuration of the speakers 208a and 208b of FIG. 4 may be identical in whole or part to the configuration of the sound output module 155 of FIG. 1.

According to an embodiment, the electronic device 101 may include a rear member 270 (or rear case). According to an embodiment, the rear member 270 may be disposed in the housing 201 (e.g., the second housing 220). According to an embodiment, the rear member 270 may accommodate at least one antenna 275.

According to an embodiment, the electronic device 101 may include an antenna 275. The antennas 275a and 275b may include, e.g., an ultra-wide band (UWB) antenna 275a, a near-field communication (NFC) antenna, a wireless charging antenna, and/or a magnetic secure transmission (MST) antenna 275b. The antenna 275 may perform short-range communication with, e.g., an external device or may wirelessly transmit or receive power necessary for charging.

According to an embodiment, an antenna structure may be formed by a portion of the housing 201 or a combination thereof. For example, the antenna 275 may include a communication antenna 275c at least a portion of which is exposed to the outside and which forms at least a portion of the exterior of the electronic device 101. The communication antenna 275c may be used for communication (e.g., Wi-Fi) with an external electronic device. The communication antenna 275c may be connected to the upper portion 271a or the lower portion 271b of the rear member 270.

In the following detailed description, a configuration in which a pair of housings (or referred to as a 'housing') are coupled to be rotatable by a hinge structure is described as an example. However, it should be noted that the electronic device according to various embodiments of the disclosure is not limited thereto. For example, according to various embodiments, the electronic device may include three or more housings. In the embodiment disclosed below, a "pair of housings" may mean two rotatably-coupled housings among three or more housings.

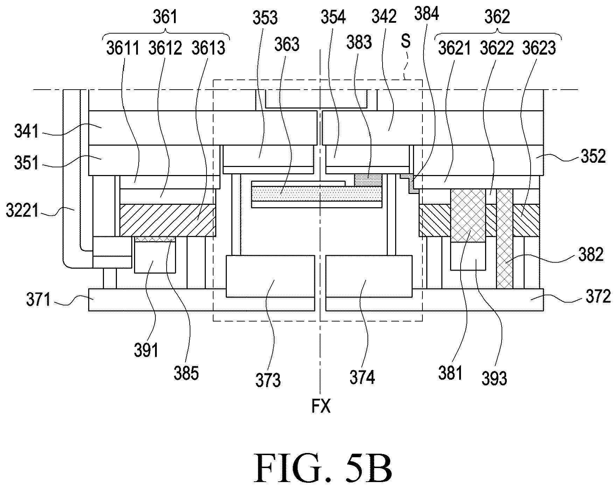

FIGS. 5A and 5B illustrate portions of a cross-sectional view of the electronic device 300. The portions of the cross-sectional view of the electronic device 300 illustrated in FIGS. 5A and 5B may include the structures (e.g., 202, 210, 220, 230, 240, 250, 260) illustrated in FIG. 4. FIG. 5A illustrates a portion of the cross-sectional view of the electronic device 300. FIG. 5B illustrates an enlarged portion of the structure illustrated in FIG. 5A.

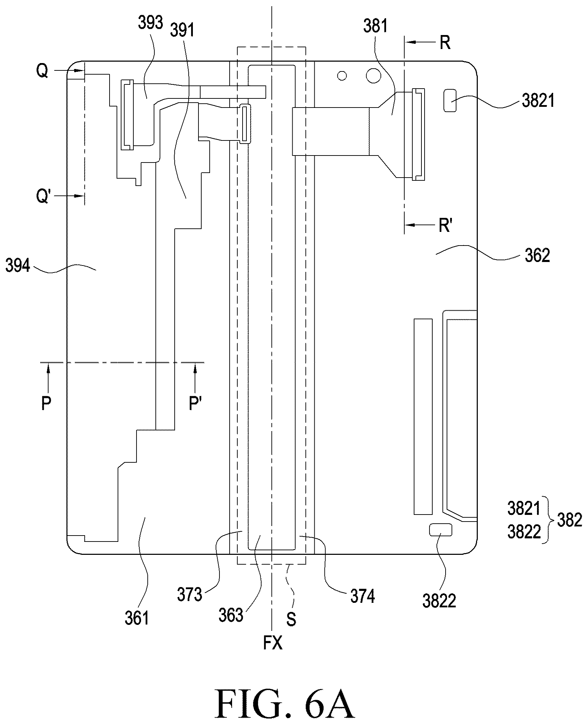

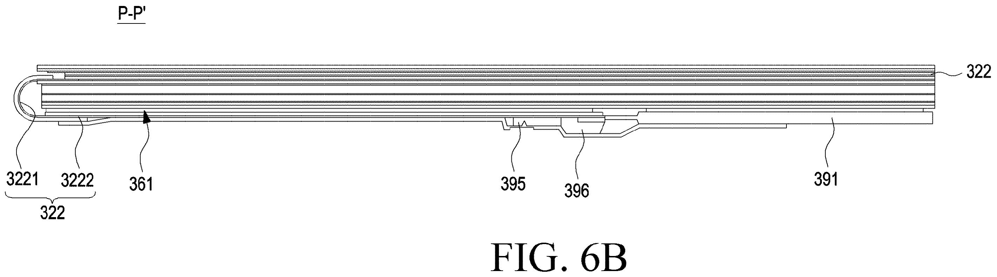

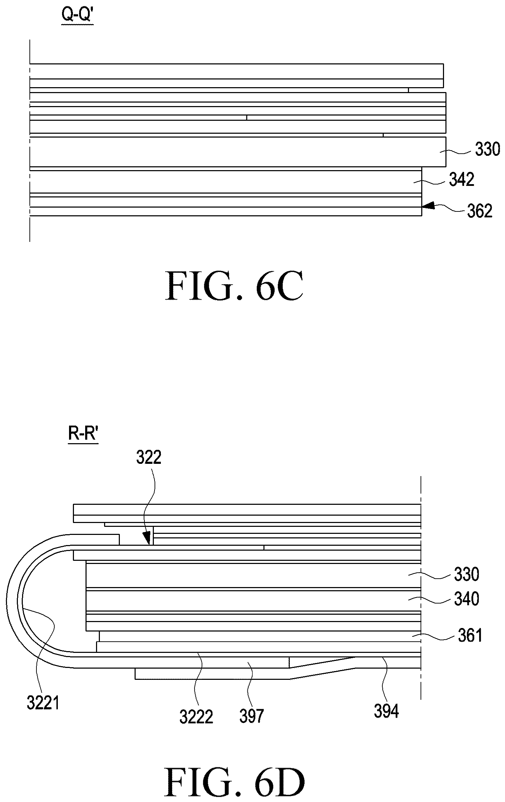

The configurations described with reference to FIGS. 5A and 5B may be identical in whole or part to the configurations described with reference to FIGS. 1 to 4. The configurations described with reference to FIGS. 5A and 5B may be identical in whole or part to the configurations described with reference to FIGS. 6 to 13.

According to an embodiment, the electronic device 300 may include a first layer 310. The first layer 310 may be a portion exposed to the outside of the electronic device 300.

According to an embodiment, the first layer 310 may include a first film 311. The first film 311 may be a portion exposed to the outside of the electronic device 300. According to an embodiment, the first layer 310 may include a window 312. The window 312 may be coupled with the first film 311. The first layer 310 may include a first adhesive layer 313. The first adhesive layer 313 may couple the first film 311 and the window 312. The first layer 310 may include a second adhesive layer 314. The second adhesive layer 314 may couple the window 312 and the second layer 320.

According to an embodiment, the electronic device 300 may include the second layer 320. The second layer 320 may be coupled with the first layer 310. The second adhesive layer 314 may couple the window 312 and the second layer 320. The second layer 320 may include a polarizing layer 321. The polarizing layer 321 may be coupled with the second adhesive layer 314. The second layer 320 may include a panel 322. The panel 322 may be coupled with the polarizing layer 321. The second layer 320 may include a third adhesive layer 324. The third adhesive layer 324 may couple the polarizing layer 321 and the panel 322. The second layer 320 may include the second film 323. The second film 323 may be coupled with the panel 322. The second layer 320 may include a fourth adhesive layer 325. The fourth adhesive layer 325 may couple the second film 323 and the reinforcement layer 330. The panel 322 may be referred to as a "flexible display."

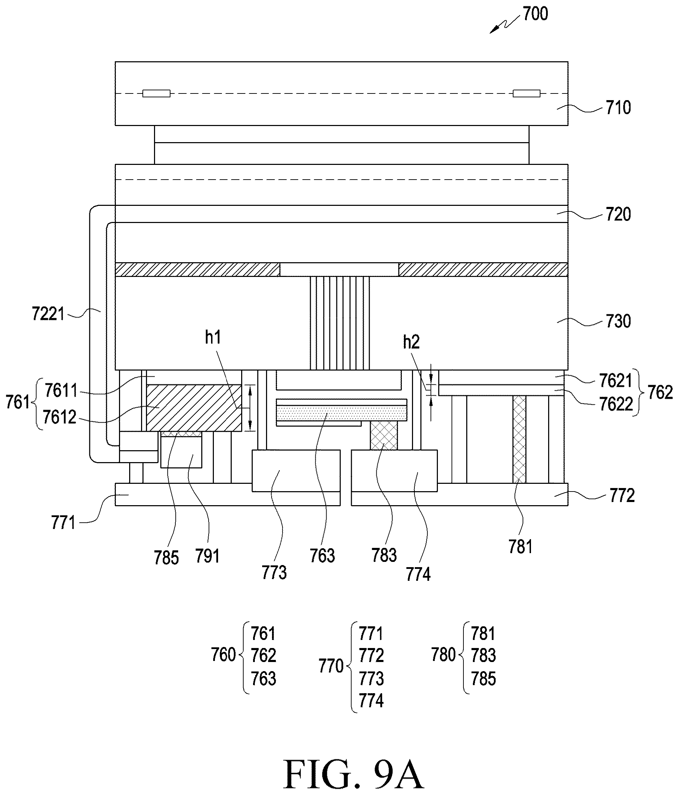

According to an embodiment, the electronic device 300 may include a reinforcement layer 330. The reinforcement layer 330 may be disposed between the panel 322 and the digitizer 340. The reinforcement layer 330 may include a non-conductive material. The reinforcement layer 330 may include a carbon fiber reinforced plastics (CFRP) material. The reinforcement layer 330 may be coupled with the digitizer 340 through the fifth adhesive layer 331. The reinforcement layer 330 may be disposed between the panel 322 and the support body 370. The reinforcement layer 330 may be disposed between the panel 322 and the support layer 360. According to an embodiment of the disclosure, the electronic device (e.g., 700 of FIG. 9A or 800 of FIG. 10) may include a reinforcement layer (e.g., 730 of FIG. 9A or 830 of FIG. 10), and may not include a digitizer. In this case (e.g., the embodiment of FIG. 9A to FIG. 10), the reinforcement layer (e.g., 730 of FIG. 9A or 830 of FIG. 10) may be disposed between the panel (e.g., 720 of FIG. 9A or 820 of FIG. 10) and the support layer (e.g., 760 of FIG. 9A or 860 of FIG. 10).

According to an embodiment, the electronic device 300 may include a digitizer 340. The digitizer 340 may be disposed between the reinforcement layer 330 and the shielding layer 350. The digitizer 340 may detect an electronic pen (not illustrated) (e.g., a stylus pen) outside the electronic device 300 through a method of touch sensing, pressure sensing, or magnetic field detection. For example, the digitizer 340 may detect the movement or contact of an electronic pen (not illustrated) (e.g., a stylus pen) outside the electronic device 300. However, according to an embodiment of the disclosure, the digitizer may not be disposed.

According to an embodiment, the digitizer 340 may include a first digitizer 341. The digitizer 340 may include a second digitizer 342. The first digitizer 341 and the second digitizer 342 may be spaced apart from each other. For example, the first digitizer 341 and the second digitizer 342 may be spaced apart from each other with a folding axis FX therebetween. The first digitizer 341 may be disposed between at least a portion of the panel bending portion 3221 and the second digitizer 342. The digitizer 340 may be divided into a first digitizer 341 positioned adjacent to the panel bending portion 3221 and a second digitizer 342 positioned away from the panel bending portion 3221.

According to an embodiment, the electronic device 300 may include a shielding layer 350. The shielding layer 350 may be disposed between the digitizer 340 and the support layer 360. The shielding layer 350 may reduce or limit noise and electromagnetic interference generated from the panel 322 and the digitizer 340.

According to an embodiment, the shielding layer 350 may include a first shielding layer 351. The shielding layer 350 may include a second shielding layer 352. The first shielding layer 351 and the second shielding layer 352 may be spaced apart from each other with a folding axis FX therebetween. The first shielding layer 351 may be disposed to correspond to the first digitizer 341. The second shielding layer 352 may be disposed to correspond to the second digitizer 342. The first shielding layer 351 may be disposed between at least a portion of the panel bending portion 3221 and the second shielding layer 352.

According to an embodiment, the electronic device 300 may include a support layer 360. The support layer 360 may be disposed between the shielding layer 350 and the support body 370. The support layer 360 may provide rigidity to the electronic device 300 of a structure that folds or unfolds. For example, the support layer 360 may support structures (e.g., 310, 320, 330, 340, 350) disposed on the upper side of the support layer 360. For example, as it is at least partially formed of a highly rigid metallic material, the support layer 360 may reduce or limit misalignment of the structures (e.g., 310, 320, 330, 340, 350, 360, 370) in an area adjacent to the folding axis FX when the electronic device 300 is folded or unfolded. For example, the support layer 360 may mitigate the impact transferred to other structures (e.g., 310, 320, 330, 340, 350, 370) when an impact is applied to the electronic device 300 from the outside. The support layer 360 may provide a grounding structure for the panel 322 and the digitizer 340.

According to an embodiment, the support layer 360 may include a first support layer 361. The support layer 360 may include a second support layer 362. The first support layer 361 and the second support layer 362 may be spaced apart from each other. For example, the first support layer 361 and the second support layer 362 may be spaced apart from each other with the folding axis FX disposed therebetween. The first support layer 361 may be disposed between at least a portion of the panel bending portion 3221 and the folding area S. The support layer 360 may be divided into a first support layer 361 adjacent to the panel bending portion 3221 and a second support layer 362 positioned farther from the panel bending portion 3221 than the first support layer 361. The first support layer 361 and the second support layer 362 may be spaced apart from each other with the folding area S disposed therebetween. The first support layer 361 may be disposed to correspond to the first digitizer 341. The second support layer 362 may be disposed to correspond to the second digitizer 342.

According to an embodiment, the support layer 360 may include a third support layer 363. The third support layer 363 may be disposed between the first support layer 361 and the second support layer 362. The third support layer 363 may be disposed inside the folding area S. The folding axis FX may extend through the third support layer 363.

According to an embodiment, the electronic device 300 may include a support body 370. The support body 370 may be a portion of a hinge assembly (e.g., 202 of FIG. 4) or may be a separate structure disposed between the hinge assembly (e.g., 202 of FIG. 4) and the support layer 360. The support body 370, as a portion of the hinge assembly (e.g., 202 of FIG. 4), may provide the folding axis FX, which serves as a reference for folding or unfolding the electronic device 300. The support body 370 may support structures (e.g., 310, 320, 330, 340, 350, 360) that fold or unfold with respect to the folding axis FX.

According to an embodiment, the support body 370 may include a first support body 371. The support body 370 may include a second support body 372. The first support body 371 and the second support body 372 may be spaced apart from each other with the folding axis FX disposed therebetween. The first support body 371 may be disposed to correspond to the first digitizer 341. The second support body 372 may be disposed to correspond to the second digitizer 342. The support body 370 may be a portion of a housing (e.g., 201 of FIG. 4). The first support body 371 may be a portion of a first housing (e.g., 210 of FIG. 4). The second support body 372 may be a portion of a second housing (e.g., 220 of FIG. 4). The first support body 371 may be at least portion of a first support area (e.g., 212 of FIG. 4). The second support body 372 may be at least portion of a second support area (e.g., 222 of FIG. 4).

According to an embodiment, the first support layer 361 may be disposed between the first digitizer 341 and the first support body 371. The second support layer 362 may be disposed between the second digitizer 342 and the second support body 372.

According to an embodiment, the electronic device 300 may include a ground member 380. The ground member 380 may provide a grounding structure to the panel 322 or the digitizer 340. A plurality of ground members 380 may be disposed to be spaced apart from each other. The ground member 380 may be connected to the support layer 360.

According to an embodiment, the electronic device 300 may include a circuit board 391. The circuit board 391 may be an FPCB. The circuit board 391 may include a flexible material. The circuit board 391 may be electrically connected to the panel 322. The circuit board 391 may be electrically connected to the digitizer 340.

According to an embodiment, the electronic device 300 may include a panel bending portion 3221. The panel bending portion 3221 may include a flexible material. The panel bending portion 3221 may be a portion of the panel 322. The panel 322 may be formed with at least a portion being bent. The panel bending portion 3221 may bend and extend from the second layer 320. The panel bending portion 3221 may extend between the support layer 360 and the support body 370 and be coupled to the circuit substrate 391. The panel bending portion 3221 may extend at a position spaced apart from the plurality of layers 320, 330, 340, 350, 360.

According to an embodiment, the electronic device 300 may include waterproofing members 355, 356, 357, 358. The waterproofing members 355, 356, 357, 358 may reduce or limit moisture penetration to electromagnetic components (e.g., 340, 350, 360, 370, 380, 391). The waterproofing members 355, 356, 357, 358 may include a first waterproofing member 355 disposed between the support layer 360 and the support body 370. The waterproofing members 355, 356, 357, 358 may include a second waterproofing member 356 disposed between the support layer 360 and the support body 370. The second waterproofing member 356 may be disposed between the first waterproofing member 355 and the folding area S. The waterproofing members 355, 356, 357, 358 may include a third waterproofing member 357 disposed between the shielding layer 350 and the support body 370. The third waterproofing member 357 may be disposed between the second waterproofing member 356 and the third support layer 363. The waterproofing members 355, 356, 357, 358 may include a substrate waterproofing member 358 disposed between the support layer 360 and the panel bending portion 3221. The substrate waterproofing member 358 may reduce or limit moisture penetration to the circuit substrate 391 and the panel bending portion 3221. The first, second, and third waterproofing members 355, 356, 357 may be integrally formed. The first, second, and third waterproofing members 355, 356, 357 may be coupled to the surface of the support body 370 and may extend along the perimeter of the support body 370. The first, second, and third waterproofing members 355, 356, 357 may be connected to each other on the surface of the support body 370. The first, second, and third waterproofing members 355, 356, 357 may be spaced apart from each other in a direction away from the folding axis FX.

According to an embodiment, the electronic device 300 may include the folding axis FX. The folding axis FX may be a reference along which structures of the electronic device 300, including a housing (e.g., 210, 220 of FIG. 4), are folded or unfolded. The hinge assembly (e.g., 202 of FIG. 4) may provide the folding axis FX of the electronic device 300. The folding axis FX may be formed between the first digitizer 341 and the second digitizer 342. The folding axis FX may be formed between the first shielding layer 351 and the second shielding layer 352. The folding axis FX may be formed between the first support layer 361 and the second support layer 362. The folding axis FX may be formed between the first support body 371 and the second support body 372. The folding axis FX may traverse the third support layer 363. The folding axis FX may be formed between the first support plate 373 and the second support plate 374. The folding axis FX may be formed between a 1-1th shielding layer 353 and a 2-1th shielding layer 354.

According to an embodiment, the electronic device 300 may include a folding area S. The folding axis FX may extend through the folding area S. The folding area S may be a space where the structures of the electronic device 300, including the housing (e.g., 210, 220 of FIG. 4), may be folded or unfolded. The folding area S may be a portion of the space of the electronic device 300 that includes the folding axis FX. The folding area S may be formed between the first shielding layer 351 and the second shielding layer 352. The folding area S may be formed between the first support layer 361 and the second support layer 362. The folding area S may be defined as a space formed between the first support layer 361 and the second support layer 362. The 1-1th shielding layer 353 and the 2-1th shielding layer 354 may be positioned within the folding area S. The third support layer 363 may be positioned within the folding area S. The first support plate 373 and the second support plate 374 may be positioned within the folding area S.

According to an embodiment, the shielding layer 350 may include a 1-1th shielding layer 353. The 1-1th shielding layer 353 may be spaced apart from the first shielding layer 351. The 1-1th shielding layer 353 may be positioned within the folding area S, and the first shielding layer 351 may be positioned outside the folding area S. The shielding layer 350 may include a 2-1th shielding layer 354. The 2-1th shielding layer 354 may be spaced apart from the second shielding layer 352. The 2-1th shielding layer 354 may be positioned within the folding area S, and the second shielding layer 352 may be positioned outside the folding area S.

According to an embodiment, the support body 370 may include a first support plate 373. The support body 370 may include a second support plate 374. The first support plate 373 may be coupled with the first support body 371. The second support plate 374 may be coupled with the second support body 372. The first support plate 373 and the second support plate 374 may be spaced apart from each other with the folding axis FX disposed therebetween. The first support plate 373 and the second support plate 374 may be positioned within the folding area S. The first support plate 373 and the second support plate 374 may be included in the hinge assembly (e.g., 202 of FIG. 4). The first support plate 373 and the second support plate 374 may be a portion of the hinge assembly (e.g., 202 of FIG. 4). The folding axis FX) may be formed between the first support plate 373 and the second support plate 374 of the hinge assembly (e.g., 202 of FIG. 4). The first support plate 373 may be coupled to the first support area (e.g., 212 of FIG. 4). The second support plate 374 may be coupled to the second support area (e.g., 222 of FIG. 4).

According to an embodiment, the first support layer 361 and the second support layer 362 may be spaced apart from each other with the folding area S disposed therebetween. The first support layer 361 may be disposed between the panel bending portion 3221 and the folding area S. The second support layer 362 may be disposed outside the folding area S.

According to an embodiment, the first support layer 361 and the second support layer 362 may include different materials from each other. For example, the first support layer 361 may include a conductive material, and a portion of the second support layer 362 may include a non-conductive material. The electronic device 300 may include a driving unit 391, 322. The driving unit 391, 322 may include a circuit board 391 and a panel bonding portion 3221. The first support layer 361 may be positioned adjacent to the driving unit 391, 322, and the second support layer 362 may be positioned farther from the driving unit 391, 322 than the first support layer 361. The first support layer 361, which is positioned adjacent to the driving unit 391, 322 more than the second support layer 362, may include a conductive material. The second support layer 362, which is positioned farther from the driving unit 391, 322 than the first support layer 361, may include a portion that is a non-conductive material. At least a portion of the second support layer 362 may include a material different from the first support layer 361.

According to an embodiment, the first support layer 361 may include a first conductive layer 3611. The first support layer 361 may include a first bonding layer 3612. The first support layer 361 may include a first reinforcement layer 3613. The first conductive layer 3611 may include a conductive material. The first conductive layer 3611 may include copper (Cu). The first conductive layer 3611 may include a mixture of copper (Cu) and a synthetic resin (PET) material. The first conductive layer 3611 may be disposed between the first shielding layer 351 and the first bonding layer 3612. The first bonding layer 3612 may be disposed between the first conductive layer 3611 and the first reinforcement layer 3613, and may couple the first conductive layer 3611 and the first reinforcement layer 3613. The first reinforcement layer 3613 may include a conductive material. The first reinforcement layer 3613 may include stainless steel. The first reinforcement layer 3613 may be disposed between the first conductive layer 3611 and the first support body 371. The first reinforcement layer 3613 may be disposed between the first conductive layer 3611 and the circuit substrate 391.

According to an embodiment, the second support layer 362 may include a second conductive layer 3621. The second support layer 362 may include a second bonding layer 3622. The second support layer 362 may include a second reinforcement layer 3623. The second conductive layer 3621 may include a conductive material. The second conductive layer 3621 may include copper (Cu). The second conductive layer 3621 may include a mixture of copper (Cu) and a synthetic resin (PET) material. The second conductive layer 3621 may be disposed between the second shielding layer 352 and the second bonding layer 3622. The second bonding layer 3622 may be disposed between the second conductive layer 3621 and the second reinforcement layer 3623, and may couple the second conductive layer 3621 and the second reinforcement layer 3623. The second reinforcement layer 3623 may include a non-conductive material. The second reinforcement layer 3623 may include flame retardant-4 (FR-4). The FR-4 material may include a material in which glass fibers impregnated with epoxy resin are stacked in multiple layers. The second reinforcement layer 3623 may include a synthetic resin (e.g., PET). The second reinforcement layer 3623 may include a carbon fiber reinforced plastics (CFRP) material. The second reinforcement layer 3623 may be disposed between the second conductive layer 3621 and the second support body 372. The second reinforcement layer 3623 may be disposed between the second conductive layer 3621 and the digitizer connection circuit 393.

According to an embodiment, the first reinforcement layer 3613 may be heavier than the second reinforcement layer 3623. The electronic device according to various embodiments of the disclosure may reduce the overall weight of the electronic device by using a material lighter than the first support layer for a portion of the second support layer.

According to an embodiment, the electronic device 300 may include a digitizer connection circuit 393. The digitizer connection circuit 393 may be electrically connected to the digitizer 340. The digitizer connection circuit 393 may be coupled with the second support layer 362. The digitizer connection circuit 393 may be disposed between the second support layer 362 and the second support body 372.

According to an embodiment, the ground member 380 may include a first ground member 381. The first ground member 381 may connect the digitizer connection circuit 393 and the second conductive layer 3621. The first ground member 381 may pass through the second bonding layer 3622 and the second reinforcement layer 3623 to connect to the second conductive layer 3621. In the second bonding layer 3622 and the second reinforcement layer 3623, a hole through which the first ground member 381 penetrates may be formed.

According to an embodiment, the ground member 380 may include a second ground member 382. The second ground member 382 may connect the second conductive layer 3621 and the second support body 372. The second ground member 382 may pass through the second bonding layer 3622 and the second reinforcement layer 3623 to connect to the second support body 372. In the second bonding layer 3622 and the second reinforcement layer 3623, a hole through which the second ground member 382 penetrates may be formed.

According to an embodiment, the digitizer connection circuit 393 and the second conductive layer 3621 may be grounded by the first and second ground members 381, 382.

Due to the structure of the first and second ground members 381 and 382 according to an embodiment, a stable grounding structure may be provided for the digitizer 340 and the digitizer connection circuit 393.

According to an embodiment, the ground member 380 may include a third ground member 383. The third ground member 383 may connect the third support layer 363 and the 2-1th shielding layer 354. The third ground member 383 may contact the lower portion of the 2-1th shielding layer 354, and the 2-1th shielding layer 354 may be a conductive material.

According to an embodiment, the ground member 380 may include a fourth ground member 384. The fourth ground member 384 may connect the 2-1th shielding layer 354 and the second conductive layer 3621. The fourth ground member 384 may contact the second conductive layer 3621 and the second bonding layer 3622.

According to an embodiment, the third support layer 363 may be grounded by the third and fourth ground members 383 and 384.

According to an embodiment, the ground member 380 may include a substrate ground member 385. The substrate ground member 385 may connect the circuit substrate 391 and the second reinforcement layer 3613. The driving unit 391, 322 may be grounded by the substrate ground member 385.

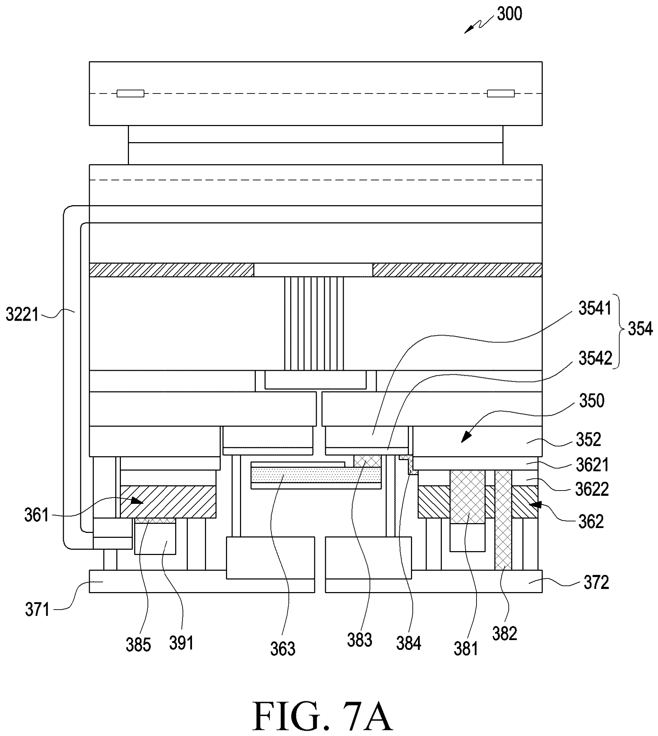

FIG. 6A illustrates the support layer 360 and the support body 370 in an unfolded state. The configurations described with reference to FIG. 6A may be identical in whole or part to the configurations described with reference to FIGS. 1 to 5b. The configurations described with reference to FIG. 6A may be identical in whole or part to the configurations described with reference to FIGS. 7A to 13.

According to an embodiment, the first support layer 361 and the second support layer 362 may be symmetrical about the folding axis FX. The first support layer 361 may include a conductive material and may be connected to electrical components (e.g., 391, 322, 393).

According to an embodiment, the first support layer 361 and the second support layer 362 may be symmetrical about the folding area S. The first support plate 373 and the second support plate 374 may be exposed outside the folding area S. The third support layer 363 may be exposed outside the folding area S.

According to an embodiment, the first ground member 381 and the second ground member 382 may penetrate at least a portion of the second support layer 362. The first ground member 381 may be positioned more adjacent to the folding axis FX than the second ground member 382 is. A plurality of second ground members 382 may be disposed. The second ground member 382 may include a 2-1th ground member 3821 and a 2-2th ground member 3822. The 2-1th ground member 3821 and the 2-2th ground member 3822 may be spaced apart parallel to the extension direction of the folding axis FX.

According to an embodiment, the electronic device 300 may include a panel driving unit cover 394. The panel driving unit cover 394 may face at least a portion of the first support layer 361. The panel driving unit cover 394 may be connected to the circuit board 391.

FIG. 6B is a cross-sectional view taken along line P-P' of the structure illustrated in FIG. 6A. FIG. 6C is a cross-sectional view taken along line Q-Q' of the structure illustrated in FIG. 6A. FIG. 6D is a cross-sectional view taken along line R-R' of the structure illustrated in FIG. 6A. The components described with reference to FIGS. 6B to 6D may be identical in whole or part to the components described with reference to FIGS. 1 to 6A. The components described with reference to FIGS. 6B to 6D may be identical in whole or part to the components described with reference to FIGS. 7A to 13.

According to an embodiment, the panel 322 may be formed with at least a portion bent. The panel 322 may include the panel bending portion 3221. The panel bending portion 3221 may bend and extend at a position spaced apart from the first support layer 361. The panel 322 may include a panel extension portion 3222. The panel extension portion 3222 may connect the panel bending portion 3221 and the circuit board 391. The panel extension portion 3222 may be disposed between the panel driving unit cover 394 and the first support layer 361.

According to an embodiment, the electronic device 300 may include a panel driving unit 395. The panel driving unit 395 may be a display driver IC (DDI). The panel driving unit 395 may be electrically connected to the panel 322. The electronic device 300 may include a panel driving unit reinforcement member 396. The panel driving unit reinforcement member 396 may be a cover resin dispensing (CRD). The panel driving unit reinforcement member 396 may be disposed at the portion where the panel 322 and the circuit board 391 are connected. The electronic device 300 may include a panel bending portion reinforcement member 397. The panel bending portion reinforcement member 397 may be a bending protect layer (BPL). The panel bending portion reinforcement member 397 may be disposed between the panel extension portion 3222 and the panel driving unit cover 394. The panel bending portion reinforcement member 397 may wrap at least a portion of the panel bending portion 3221.

FIGS. 7A to 7D illustrate grounding structures according to various embodiments of the disclosure.

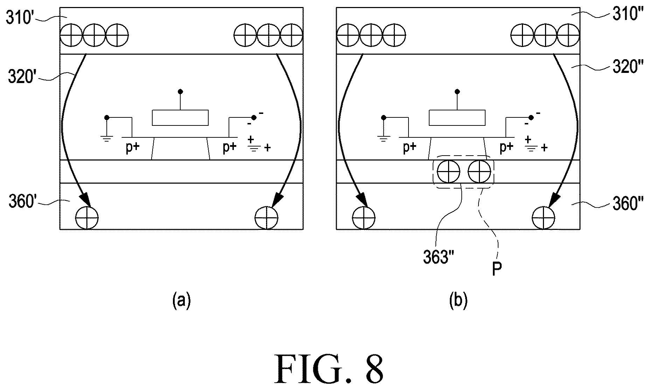

The configurations described with reference to FIGS. 7A to 7D may be identical in whole or part to the configurations described with reference to FIGS. 1 to 6D. The configurations described with reference to FIGS. 7A to 7D may be identical in whole or part to the configurations described with reference to FIGS. 8 to 13.

Referring to FIG. 7A, the electronic device 300 may include ground members 381, 382, 383, 384, 385. The content of the electronic device 300 described with reference to FIGS. 1 to 6D may be equally applied to the description of the electronic device 300 of FIG. 7A.

According to an embodiment, the third and fourth ground members 383, 384 may contact the shielding layer 350. The third and fourth ground members 383, 384 may be grounded by the shielding layer 350 and the second conductive layer 3621. The shielding layer 350 may include a first shielding portion 3541. The first shielding portion 3541 may be a non-conductive material. The shielding layer 350 may include a second shielding portion 3542. The second shielding portion 3542 may be a conductive material. The first shielding portion 3541 and the second shielding portion 3542 may be a portion of the 2-1th shielding layer 354. The first shielding portion 3541 may have the same material as the second shielding layer 352. The second shielding portion 3542 may have the same material as the second conductive layer 3621. The third ground member 383 may connect the second shielding portion 3542 and the third support layer 363. The fourth ground member 384 may connect the second shielding portion 3542 and the second conductive layer 3621.

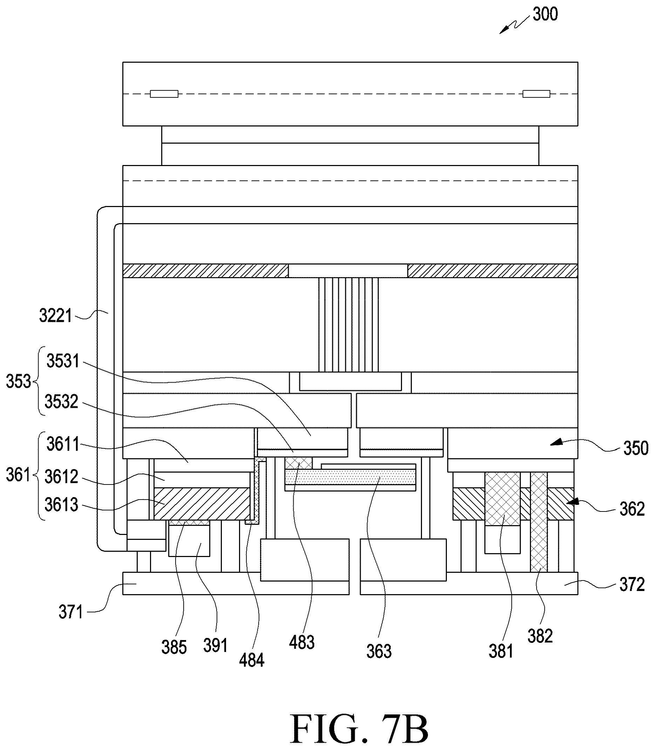

Referring to FIG. 7B, the electronic device 300 may include ground members 381, 382, 483, 484, and 385. The content of the electronic device 300 described with reference to FIGS. 1 to 6D may be equally applied to the description of the electronic device 300 of FIG. 7B.

According to an embodiment, the third and fourth ground members 483, 484 may contact the shielding layer 350. The third and fourth ground members 483 and 484 may be grounded by the shielding layer 350 and the first conductive layer 3611. The shielding layer 350 may include a first shielding portion 3531. The first shielding portion 3531 may be a non-conductive material. The shielding layer 350 may include a second shielding portion 3532. The second shielding portion 3532 may be a conductive material. The first shielding portion 3531 and the second shielding portion 3532 may be a portion of the 1-1th shielding layer 353. The first shielding portion 3531 may have the same material as the first shielding layer 351. The second shielding portion 3532 may have the same material as the first conductive layer 3611. The third ground member 483 may connect the second shielding portion 3532 and the third support layer 363. The fourth ground member 484 may connect the second shielding portion 3532 and the first conductive layer 3611.

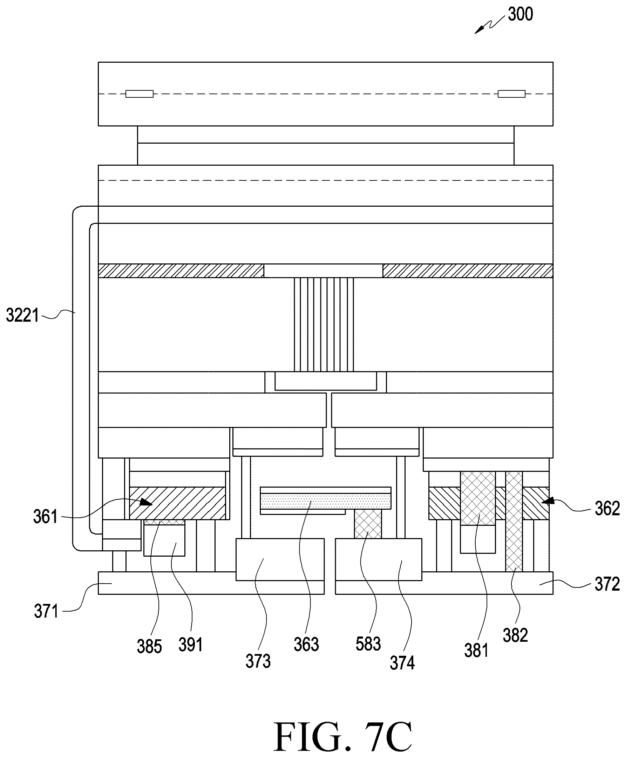

Referring to FIG. 7C, the electronic device 300 may include ground members 381, 382, 583, 385. The content of the electronic device 300 described with reference to FIGS. 1 to 6 may be equally applied to the description of the electronic device 300 of FIG. 7C.

According to an embodiment, the third ground member 583 connected to the third support layer 363 may contact the support plate 374. The third ground member 583 may be grounded by the second support plate 374. The second support plate 374 may include a conductive material. The third ground member 583 may connect the second support plate 374 and the third support layer 363.

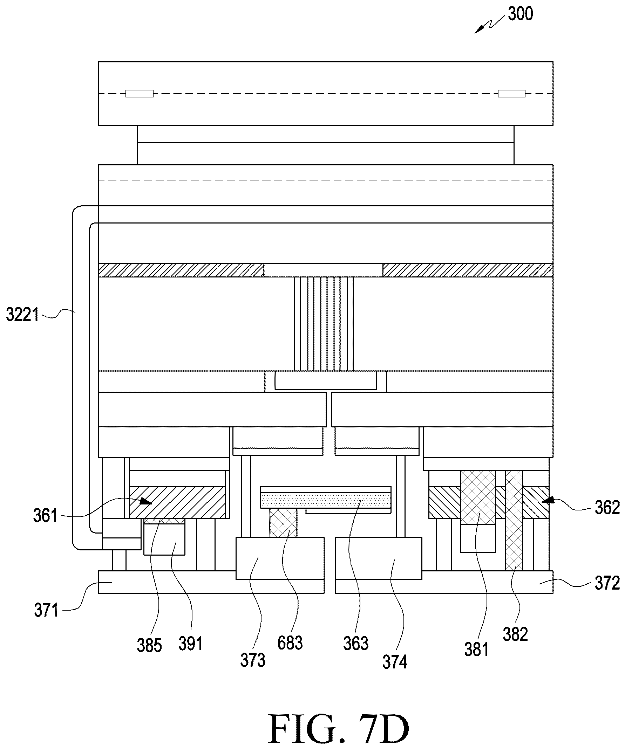

Referring to FIG. 7D, the electronic device 300 may include ground members 381, 382, 683, 385. The content of the electronic device 300 described with reference to FIGS. 1 to 6D may be equally applied to the description of the electronic device 300 of FIG. 7D.

According to an embodiment, the third ground member 683 connected to the third support layer 363 may contact the support plate 373. The third ground member 683 may be grounded by the first support plate 373. The first support plate 373 may include a conductive material. The third ground member 683 may connect the first support plate 373 and the third support layer 363.

FIG. 8(a) conceptually illustrates the phenomenon when the above-described third support layer (e.g., 363 of FIG. 5B) is not disposed. FIG. 8(b) conceptually illustrates the phenomenon when the above-described third support layer (e.g., 363 of FIG. 5B) is not grounded.

The configurations described with reference to FIG. 8 may be identical in whole or part to the configurations described with reference to FIGS. 1 to 7D. The configurations described with reference to FIG. 8 may be identical in whole or part to the configurations described with reference to FIGS. 9A to 13.

According to a comparative embodiment as illustrated in FIG. 8(a), the third support layer 363 illustrated in FIG. 5B may not be disposed. In this case, a uniform electric field may be formed in the second layer 320' between the first layer 310' and the support layer 360'. However, according to this comparative embodiment, since the support layer 360' is thick and heavy, the electronic device becomes heavy and thick.

According to a comparative embodiment as illustrated in FIG. 8(b), a third support layer 363" as illustrated in FIG. 5B may be disposed. However, the comparative embodiment of FIG. 8(b) illustrates a case where the third support layer 363" is not grounded, in which case a non-uniform electric field may be formed in the second layer 320" between the first layer 310" and the support layer 360". In the comparative embodiment of FIG. 8(b), due to the third support layer 363" not being grounded, the local charge P may be formed near the third support layer 363", and charge floating may occur.

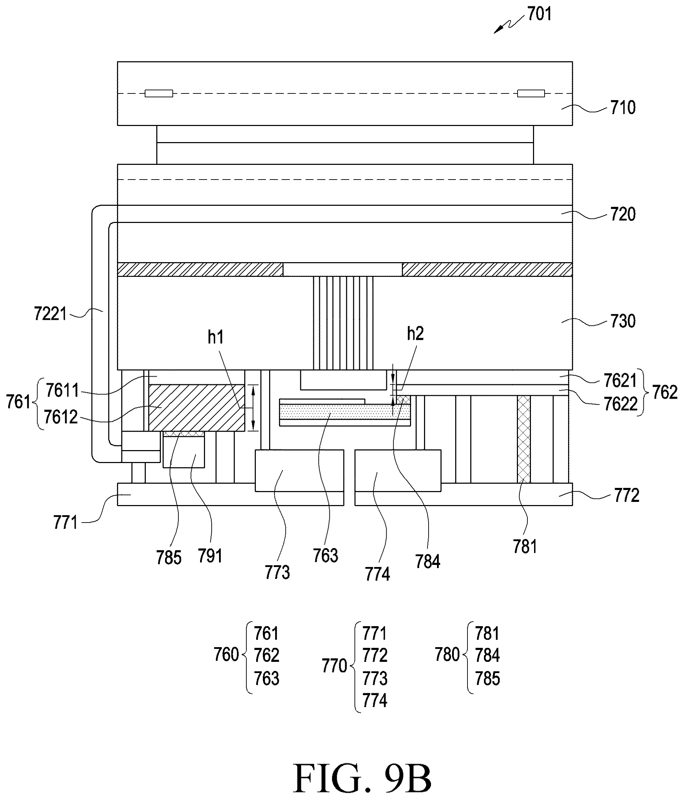

FIG. 9A is a cross-sectional view illustrating a portion of an electronic device 700 according to an embodiment of the disclosure. The configurations described with reference to FIG. 9A may be identical in whole or part to the configurations described with reference to FIGS. 1 to 8. The configurations described with reference to FIG. 9A may be identical in whole or part to the configurations described with reference to FIGS. 9B to 13.

According to an embodiment, the electronic device 700 may include a first layer 710 and a second layer 720. The description of the first layer 310 described with reference to FIG. 5A may be equally applied to the description of the first layer 710. The description of the second layer 320 described with reference to FIG. 5A may be equally applied to the description of the second layer 720.

According to an embodiment, the electronic device 700 may include a reinforcement layer 730. The reinforcement layer 730 may include a non-conductive material. The reinforcement layer 730 may include a carbon fiber reinforced plastics (CFRP) material.

The electronic device 700 according to an embodiment of the disclosure may not have the digitizer 340 described with reference to FIGS. 1 to 8 disposed therein. The reinforcement layer 730 of the electronic device 700 may be coupled with at least a portion of the support layer 760. The reinforcement layer 730 may be coupled with the first and second support layers 761 and 762. The reinforcement layer 730 may be spaced apart from the third support layer 763. The third support layer 763 may be disposed between the reinforcement layer 730 and the support plates 773 and 774.

According to an embodiment, the electronic device 700 may include a support layer 760. The support layer 760 may be disposed between the reinforcement layer 730 and the support body 770. The support layer 760 may include a conductive material.

According to an embodiment, the support layer 760 may include a first support layer 761. The support layer 760 may include a second support layer 762. The first support layer 761 and the second support layer 762 may be spaced apart from each other with the folding axis (e.g., FX of FIG. 5B) disposed therebetween. The first support layer 761 may be disposed adjacent to the driving unit 791. The second support layer 762 may be positioned farther from the driving unit 791 than the first support layer 761. The first support layer 761 may be disposed between the panel bending portion 7221 and the second support layer 762.

According to an embodiment, the first support layer 761 may include a first bonding layer 7611. The first support layer 761 may include a first conductive layer 7612. The first bonding layer 7611 may be disposed between the reinforcement layer 730 and the first conductive layer 7612, and may couple the reinforcement layer 730 and the first conductive layer 7612. The first conductive layer 7612 may be stainless steel or copper (Cu).

According to an embodiment, the second support layer 762 may include a second bonding layer 7621. The second support layer 762 may include a second conductive layer 7622. The second bonding layer 7621 may be disposed between the reinforcement layer 730 and the second conductive layer 7622, and may couple the reinforcement layer 730 and the second conductive layer 7622. The second conductive layer 7622 may be stainless steel or copper (Cu).

According to an embodiment, the first conductive layer 7612 and the second conductive layer 7622 may have different thicknesses. For example, the thickness h1 of the first conductive layer 7612 may be larger than the thickness h2 of the second conductive layer 7622. By reducing the thickness of the second support layer 762, which is positioned far from the driving unit 791, the weight of the electronic device 700 may be decreased.

According to an embodiment, the electronic device 700 may include a third support layer 763. The third support layer 763 may be disposed in the folding area (e.g., S of FIG. 5B). The description of the third support layer 363 described with reference to FIG. 5B may be equally applied to the description of the third support layer 763.

According to an embodiment, the electronic device 700 may include a support body 770. The support body 770 may include a first support body 771, a second support body 772, a first support plate 773, and a second support plate 774. The description of the support body 370 described with reference to FIG. 5B may be equally applied to the description of the support body 770.

According to an embodiment, the electronic device 700 may include a ground member 780. The ground member 780 may be connected to the support layer 760. The ground member 780 may include a first ground member 781. The first ground member 781 may be disposed between the second support layer 762 and the second support body 772. The first ground member 781 may connect the second conductive layer 7622 and the second support body 772. The ground member 780 may include a third ground member 783. The third ground member 783 may connect the third support layer 763 and the second support plate 774. The middle ground member 783 may be disposed in the folding area (e.g., S of FIG. 5B). The ground member 780 may include a substrate ground member 785. The substrate ground member 785 may connect the first conductive layer 7612 and the circuit substrate 791.

FIG. 9B is a cross-sectional view illustrating a portion of an electronic device 701 according to an embodiment of the disclosure. The configurations described with reference to FIG. 9B may be identical in whole or part to the configurations described with reference to FIGS. 1 to 9A. The configurations described with reference to FIG. 9B may be identical in whole or part to the configurations described with reference to FIGS. 10 to 13.

The description of the components (e.g., 710, 720, 730, 760, 770, 780, 791, 792) described with reference to FIG. 9A may be equally applied to the description of the components (e.g., 710, 720, 730, 760, 770, 780, 791, 792) of the electronic device 701 according to an embodiment of the disclosure.

According to an embodiment, the electronic device 701 may include a ground member 780. The ground member 780 may be connected to the support layer 760. The ground member 780 may include a first ground member 781. The first ground member 781 may be disposed between the second support layer 762 and the second support body 772. The first ground member 781 may connect the second conductive layer 7622 and the second support body 772. The ground member 780 may include a third ground member 784. The third ground member 784 may connect the third support layer 763 and the second conductive layer 7622. The third ground member 784 may be disposed inside the folding area (e.g., S of FIG. 5B). The ground member 780 may include a substrate ground member 785. The substrate ground member 785 may connect the first conductive layer 7612 and the circuit substrate 791.

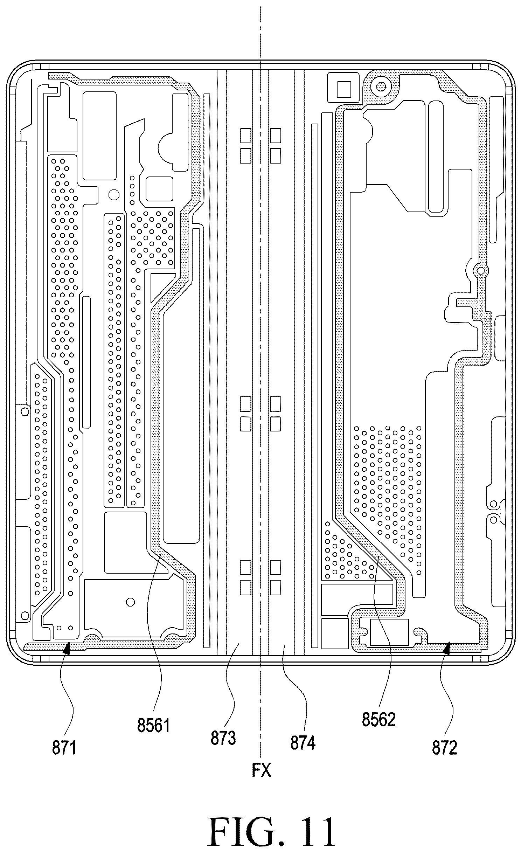

FIG. 10 is a cross-sectional view illustrating a portion of an electronic device 800 according to an embodiment of the disclosure. The components described with reference to FIG. 10 may be identical in whole or part to the components described with reference to FIGS. 1 to 9B. Some or all of the components described with reference to FIG. 10 may be the same as those described with reference to FIGS. 11 to 13.

According to an embodiment, the electronic device 800 may include a first layer 810 and a second layer 820. The description of the first layer 310 described with reference to FIG. 5A may be equally applied to the description of the first layer 810. The description of the second layer 320 described with reference to FIG. 5A may be equally applied to the description of the second layer 820.

According to an embodiment, the electronic device 800 may include a reinforcement layer 830. The reinforcement layer 830 may include a non-conductive material. The reinforcement layer 830 may include a carbon fiber reinforced plastics (CFRP) material.

The electronic device 800 according to an embodiment of the disclosure may not have the digitizer 340 described with reference to FIGS. 1 to 8 disposed therein. The reinforcement layer 830 of the electronic device 800 may be coupled with the support layer 860.

According to an embodiment, the electronic device 800 may include a support layer 860. The support layer 860 may be disposed between the reinforcement layer 830 and the support body 870. The support layer 860 may include a conductive material.

According to an embodiment, the support layer 860 may include a first support layer 861. The support layer 860 may include a second support layer 862. The first support layer 861 and the second support layer 862 may be spaced apart from each other with the folding axis FX disposed therebetween. The first support layer 861 may be disposed adjacent to the driving unit 891. The second support layer 862 may be positioned farther from the driving unit 891 than the first support layer 861. The first support layer 861 may be disposed between the panel bending portion 892 and the second support layer 862.

According to an embodiment, the first support layer 861 may include a first bonding layer 8611. The first support layer 861 may include a first conductive layer 8612. The first bonding layer 8611 may be disposed between the reinforcement layer 830 and the first conductive layer 8612, and may couple the reinforcement layer 830 and the first conductive layer 8612. The first conductive layer 8612 may include stainless steel or copper (Cu).

According to an embodiment, the second support layer 862 may include a second bonding layer 8621. The second support layer 862 may include a second conductive layer 8622. The second bonding layer 8621 may be disposed between the reinforcement layer 830 and the second conductive layer 8622, and may couple the reinforcement layer 830 and the second conductive layer 8622. The second conductive layer 8622 may be stainless steel or copper (Cu).

According to an embodiment, the first conductive layer 8612 and the second conductive layer 8622 may have different thicknesses. For example, the thickness h1 of the first conductive layer 8612 may be larger than the thickness h2 of the second conductive layer 8622. By reducing the thickness of the second support layer 862, which is positioned far from the driving unit 891, the weight of the electronic device 800 may be decreased.

The electronic device 800 according to an embodiment of the disclosure may not include a third support layer (e.g., 363 of FIG. 5A).

According to an embodiment, the electronic device 800 may include a support body 870. The support body 870 may include a first support body 871, a second support body 872, a first support plate 873, and a second support plate 874. The description of the support body 370 described with reference to FIG. 5B may be equally applied to the description of the support body 870.

According to an embodiment, the electronic device 800 may include a ground member 880. The ground member 880 may be connected to the support layer 860. The ground member 880 may include a first ground member 881. The first ground member 881 may be disposed between the second support layer 862 and the second support body 872. The first ground member 881 may connect the second conductive layer 8622 and the second support body 872. The ground member 880 may include a substrate ground member 885. The substrate ground member 885 may connect the first conductive layer 8612 and the circuit substrate 891.

According to an embodiment, the electronic device 800 may include waterproofing members 855, 856. The waterproofing members 855, 856 may be disposed between the support layer 860 and the support body 870. The waterproofing members 855, 856 may be disposed outside the folding area S.

According to an embodiment, the waterproofing members 855, 856 may include a first waterproofing member 855. The first waterproofing member 855 may include a 1-1th waterproofing member 8551. The first waterproofing member 8551 may be disposed between the first support layer 861 and the first support body 871. The first waterproofing member 855 may include a 1-2th waterproofing member 8552. The 1-2th waterproofing member 8552 may be disposed between the second support layer 862 and the second support body 872.

According to an embodiment, the waterproofing member 855, 856 may include a second waterproofing member 856. The second waterproofing member 856 may include a 2-1th waterproofing member 8561. The 2-1th waterproofing member 8561 may be disposed between the first support layer 861 and the first support body 871. The second waterproofing member 856 may include a 2-2th waterproofing member 8562. The 2-2th waterproofing member 8562 may be disposed between the second support layer 862 and the second support body 872.

According to an embodiment, the circuit board 891 may be disposed between the 1-1th waterproofing member 8551 and the 2-1th waterproofing member 8561. The first ground member 881 may be disposed between the 1-2th waterproofing member 8552 and the 2-2th waterproofing member 8562.

According to an embodiment, the thickness w1 of the 1-1th waterproofing member 8551 may be smaller than the thickness w3 of the 1-2th waterproofing member 8552. The thickness w2 of the 2-1th waterproofing member 8561 may be smaller than the thickness w4 of the 2-2th waterproofing member 8562.

According to an embodiment, the 1-1th waterproofing member 8551 and the 2-1th waterproofing member 8561 may be integrated. The 1-1th waterproofing member 8551 and the 2-1th waterproofing member 8561 may extend along the surface of the first support body (e.g., 871 of FIG. 11) and be connected to each other. The 1-1th waterproofing member 8551 and the 2-1th waterproofing member 8561 may be spaced apart from each other in a direction away from the folding axis (e.g., FX of FIG. 11). The 1-2th waterproofing member 8552 and the 2-2th waterproofing member 8562 may be integrated. The 1-2th waterproofing member 8552 and the 2-2th waterproofing member 8562 may extend along the surface of the second support body (e.g., 872 of FIG. 11) and be connected to each other. The 1-2th waterproofing member 8552 and the 2-2th waterproofing member 8562 may be spaced apart from each other in a direction away from the folding axis (e.g., FX of FIG. 11).

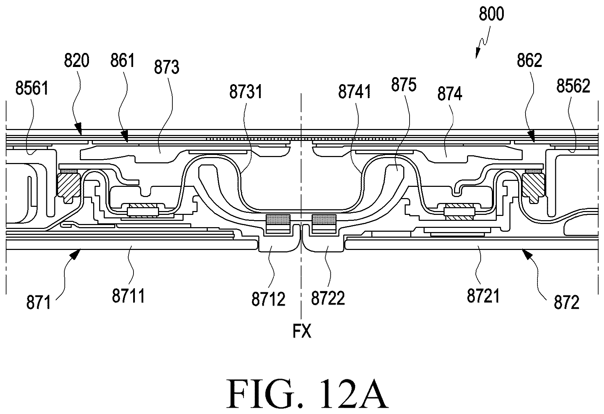

FIG. 11 illustrates some (e.g., 855, 856, 870) of the components illustrated in FIG. 10. The components described with reference to FIG. 11 may be identical in whole or part to the components described with reference to FIGS. 1 to 10. The components described with reference to FIG. 11 may be identical in whole or part to the components described with reference to FIGS. 12A to 13.

According to an embodiment, the first support body 871 and the second support body 872 may be symmetrical with respect to the folding axis FX. The first support plate 873 and the second support plate 874 may be symmetrical with respect to the folding axis FX. The first support plate 873 and the second support plate 874 may be disposed between the 2-1th waterproofing member 8561 and the 2-2th waterproofing member 8562.

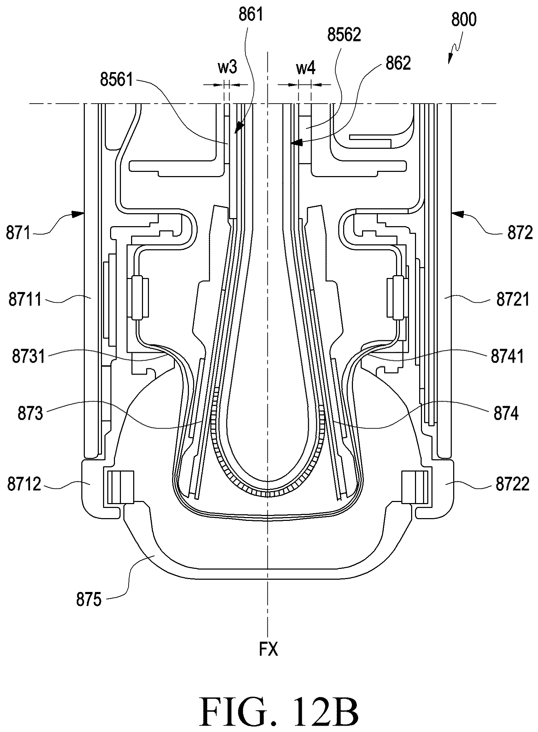

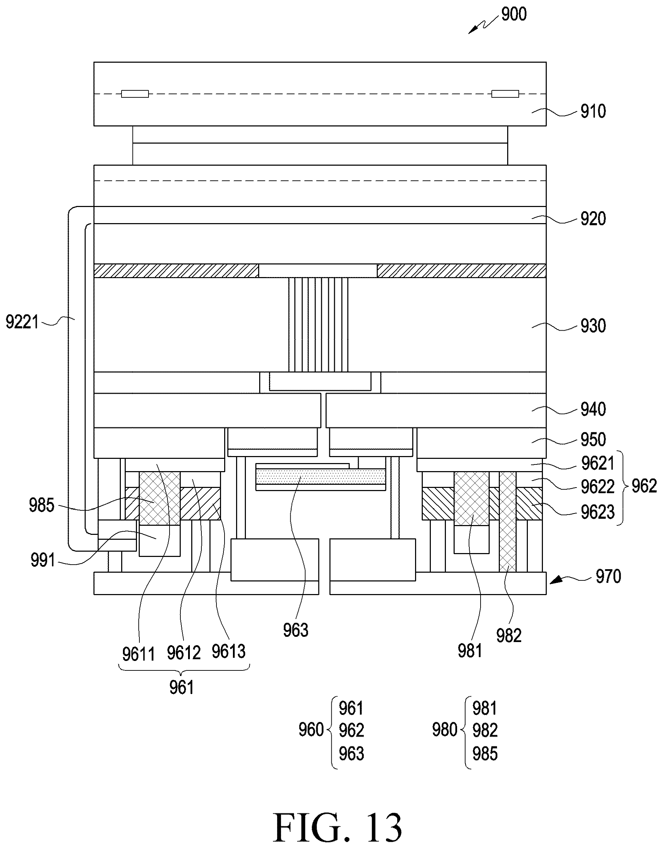

FIG. 12A illustrates a portion of a cross-sectional view of the electronic device 800 of FIG. 10 in an unfolded state. FIG. 12A illustrates a specific shape of the enlarged N area of FIG. 10 conceptually illustrating the electronic device 800. FIG. 12B illustrates a portion of a cross-sectional view of the electronic device 800 of FIG. 12A in a folded state. FIGS. 5A to 10 may conceptually illustrate a cross-sectional view of the electronic device (e.g., illustrating that the vertical width is larger than the horizontal width) for convenience of description. The components described with reference to FIGS. 12A and 12B may be identical in whole or part to the components described with reference to FIGS. 1 to 10. The components described with reference to FIGS. 12A and 12B may be identical in whole or part to the components described with reference to FIG. 13.

According to an embodiment, the electronic device 800 may include a first support body 871 and a second support body 872. The electronic device 800 may include a first support plate 873 and a second support plate 874.

According to an embodiment, the first support body 871 may include a first plate 8711. The first plate 8711 may be rotated about the folding axis FX. The first support body 871 may include a first cover portion 8712. The first cover portion 8712 may be disposed between the first plate 8711 and the folding axis FX. The first cover portion 8712 may cover a portion of the hinge assembly (e.g., 202 of FIG. 4). The first cover portion 8712 may be rotated together with the first plate 8711. The first plate 8711 and the first cover portion 8712 may be a portion of a first housing (e.g., 210 of FIG. 4).

According to an embodiment, the electronic device 800 may include a first support portion 8731. The first support portion 8731 may be disposed between the first plate 8711 and the first support plate 873. The first support portion 8731 may be a portion of the hinge assembly (e.g., 202 of FIG. 4).

According to an embodiment, the second support body 872 may include a second plate 8721. The second plate 8721 may be rotated about the folding axis FX. The second support body 872 may include a second cover portion 8722. The second cover portion 8722 may be disposed between the second plate 8721 and the folding axis FX. The second cover portion 8722 may cover a portion of the hinge assembly (e.g., 202 of FIG. 4). The second cover portion 8722 may be rotated together with the second plate 8721. The second plate 8721 and the second cover portion 8722 may be a portion of a second housing (e.g., 220 of FIG. 4).

According to an embodiment, the electronic device 800 may include a second support portion 8741. The second support portion 8741 may be disposed between the second plate 8721 and the second support plate 874. The second support portion 8741 may be a portion of the hinge assembly (e.g., 202 of FIG. 4).

According to an embodiment, the electronic device 800 may include a hinge housing 875. The folding axis FX may extend through the hinge housing 875. The first support body 871 and the second support body 872 may be moved along the extension direction of the hinge housing 875.

According to an embodiment, the electronic device 800 may be folded or unfolded. The first support body 871 may be rotated in a first direction with respect to the folding axis FX, and the second support body 872 may be rotated in a second direction opposite to the first direction with respect to the folding axis FX. The display assembly (e.g., 310, 320, 330, 340, 350, 360, 370, 380 of FIG. 5A) of the electronic device may have a predetermined shape (e.g., a waterdrop shape) when the electronic device is in a folded state. The support plates 873, 874 may support the components (e.g., 310, 320, 330, 340, 350, 360, 380 of FIG. 5A) constituting the display assembly to form the above-described predetermined shape.

According to an embodiment, the 2-1th waterproofing member 8561 may be disposed between the first support layer 861 and the first support body 871. The 2-2th waterproofing member 8562 may be disposed between the second support layer 862 and the second support body 872. As illustrated in FIG. 10, due to the thickness difference (e.g., h1, h2) between the first and second conductive layers 8612, 8622, the thickness w3 of the 2-1th waterproofing member 8561 may be smaller than the thickness w4 of the 2-2th waterproofing member 8562. As a result, the waterproof performance of the electronic device 800 may be enhanced.

FIG. 13 is a cross-sectional view illustrating a portion of an electronic device 900 according to an embodiment of the disclosure. The components described with reference to FIG. 13 may be identical in whole or part to the components described with reference to FIGS. 1 to 12B.

According to an embodiment, the electronic device 900 may include a first layer 910, a second layer 920, a reinforcement layer 930, a digitizer 940, a shielding layer 950, a support body 970, a circuit board 991, and a panel bending portion 9221. The description of the components (e.g., 310, 320, 330, 340, 350, 370, 391, 3221) described with reference to FIG. 5A may be equally applied to the description of the above-mentioned components (e.g., 910, 920, 930, 940, 950, 970, 991, 9221).

According to an embodiment, the electronic device 900 may include a support layer 960. The support layer 960 may be disposed between the shielding layer 950 and the support body 970. The support layer 960 may include a first support layer 961 and a second support layer 962. The first support layer 961 and the second support layer 962 may be spaced apart from each other with the folding axis (e.g., FX of FIG. 5B) disposed therebetween.

According to an embodiment, the first support layer 961 and the second support layer 962 may have substantially the same structure. For example, the first support layer 961 and the second support layer 962 may include a conductive layer 9611, 9621, a bonding layer 9612, 9622, and a reinforcement layer 9613, 9623. The first support layer 961 may include a first conductive layer 9611, a first bonding layer 9612, and a first reinforcement layer 9613. The second support layer 962 may include a second conductive layer 9621, a second bonding layer 9622, and a second reinforcement layer 9623. The first conductive layer 9611 and the second conductive layer 9621 may include a conductive material. For example, the first conductive layer 9611 and the second conductive layer 9621 may include a mixture of copper (Cu) and a synthetic resin (e.g., PET). The first reinforcement layer 9613 and the second reinforcement layer 9623 may include a non-conductive material. For example, the first reinforcement layer 9613 and the second reinforcement layer 9623 may include flame retardant-4 (FR-4). The FR-4 material may be a material in which glass fibers impregnated with epoxy resin are stacked in multiple layers.

According to an embodiment, the electronic device 900 may include a ground member 980. The ground member 980 may include a first ground member 981 and a second ground member 982. The description of the ground members 381 and 382 described with reference to FIG. 5B may be equally applied to the description of the first ground member 981 and the second ground member 982.

According to an embodiment, the ground member 980 may include a substrate ground member 985. The substrate ground member 985 may connect the first conductive layer 9611 and the circuit substrate 991. In the first bonding layer 9612 and the first reinforcement layer 9613, a hole through which the substrate ground member 985 penetrates may be formed.

A foldable electronic device including a flexible display places a supporting member between the display and the housing to secure the rigidity of the area where deformation occurs due to bending. The supporting member uses a metal material to secure sufficient rigidity and for connection to electronic components requiring grounding.

A typical electronic device may become heavier and thicker due to the use of a supporting member formed of heavy and thick material, thereby increasing the overall weight and thickness of the electronic device.

According to various embodiments of the disclosure, it is possible to provide an electronic device with enhanced (e.g., decreased) weight and thickness while securing sufficient rigidity to reduce or limit the distortion of the display when the electronic device is folded or unfolded.

According to various embodiments of the disclosure, it may be possible to provide a stable grounding structure to electronic components (e.g., digitizer, circuit board) while simultaneously reducing weight.

The disclosure is not limited to the foregoing embodiments but various modifications or changes may rather be made thereto without departing from the spirit and scope of the disclosure.

An electronic device according to various embodiments of the disclosure may reduce weight by having first and second support layers, spaced apart from each other with respect to the folding axis, composed of different materials. For example, as the second support layer disposed on one side of the folding axis is formed of a material relatively lighter than the metal material of the first support layer, the overall weight of the electronic device may be decreased.

An electronic device according to various embodiments of the disclosure may provide a stable grounding structure to electronic components by connecting ground members to each of the first and second support layers, spaced apart from each other with respect to the folding axis.

Effects obtainable from the disclosure are not limited to the above-mentioned effects, and other effects not mentioned may be apparent to one of ordinary skill in the art from the following description.

According to an embodiment, an electronic device (e.g., 101 of FIG. 1) comprises a first housing (e.g., 210 of FIG. 4).

According to an embodiment, the electronic device (e.g., 101 of FIG. 1) comprises a second housing (e.g., 220 of FIG. 4) movably coupled to the first housing (e.g., 210 of FIG. 4).

According to an embodiment, the electronic device (e.g., 101 of FIG. 1) comprises a flexible display (e.g., 322 of FIG. 5A) disposed in a space formed by the first housing (e.g., 210 of FIG. 4) and the second housing (e.g., 220 of FIG. 4).

According to an embodiment, the electronic device (e.g., 101 of FIG. 1) comprises a first support body (e.g., 371 of FIG. 5B) spaced apart from the flexible display (e.g., 322 of FIG. 5A).

According to an embodiment, the electronic device (e.g., 101 of FIG. 1) comprises a second support body (e.g., 372 of FIG. 5B) spaced apart from the flexible display (e.g., 322 of FIG. 5A) and forming a folding axis (e.g., FX of FIG. 5B) between the first support body (e.g., 371 of FIG. 5B) and the second support body (e.g., 372 of FIG. 5B).

According to an embodiment, the electronic device (e.g., 101 of FIG. 1) comprises a first support layer (e.g., 361 of FIG. 5B) disposed between the flexible display (e.g., 322 of FIG. 5A) and the first support body (e.g., 371 of FIG. 5B).

According to an embodiment, the electronic device (e.g., 101 of FIG. 1) comprises a second support layer (e.g., 362 of FIG. 5B) disposed between the flexible display (e.g., 322 of FIG. 5A) and the second support body (e.g., 372 of FIG. 5B).

According to an embodiment, the first support layer (e.g., 361 of FIG. 5B) and the second support layer (e.g., 362 of FIG. 5B) are spaced apart from each other with the folding axis (e.g., FX of FIG. 5B) disposed therebetween and at least partially have different materials.

According to an embodiment, the first support layer (e.g., 361 of FIG. 5B) and the second support layer (e.g., 362 of FIG. 5B) are spaced apart from each other with the folding axis (e.g., FX of FIG. 5B) disposed therebetween and have different thicknesses.

According to an embodiment, the first support layer (e.g., 361 of FIG. 5B) may include a first reinforcement layer (e.g., 3613 of FIG. 5B) disposed between the flexible display (e.g., 322 of FIG. 5A) and the first support body (e.g., 371 of FIG. 5B).

According to an embodiment, the second support layer (e.g., 362 of FIG. 5B) may include a second reinforcement layer (e.g., 3623 of FIG. 5B), which is disposed between the flexible display (e.g., 322 of FIG. 5A) and the second support body (e.g., 372 of FIG. 5B) and is lighter than the first reinforcement layer (e.g., 3613 of FIG. 5B).

According to an embodiment, the electronic device (e.g., 101 of FIG. 1) may comprise a circuit board (e.g., 391 of FIG. 5B) disposed between the first support layer (e.g., 361 of FIG. 5B) and the first support body (e.g., 371 of FIG. 5B) and electrically connected to the flexible display (e.g., 322 of FIG. 5A).

According to an embodiment, the electronic device (e.g., 101 of FIG. 1) may comprise a panel bending portion (e.g., 3221 of FIG. 5B) forming a portion of the flexible display (e.g., 322 of FIG. 5A) and connected to the circuit board (e.g., 391 of FIG. 5B).

According to an embodiment, one of the first support layer (e.g., 361 of FIG. 5B) and the second support layer (e.g., 362 of FIG. 5B) that is disposed adjacent to the connector (e.g., 392 of FIG. 5B) may be heavier than the other.

According to an embodiment, a thickness of the first support layer (e.g., 361; 761; 861 of FIGS. 5A to 10) may be larger than a thickness of the second support layer (e.g., 362; 762; 862 of FIGS. 5A to 10).

According to an embodiment, the first support layer (e.g., 361 of FIG. 5B) may include stainless steel, and the second support layer (e.g., 362 of FIG. 5B) may include FR4.

According to an embodiment, a folding area (e.g., S of FIG. 5B) penetrated by the folding axis (e.g., FX of FIG. 5B) may be formed between the first support layer (e.g., 361 of FIG. 5B) and the second support layer (e.g., 362 of FIG. 5B).

According to an embodiment, the electronic device (e.g., 101 of FIG. 1) may comprise a third support layer (e.g., 363 of FIG. 5B) disposed between the first support layer (e.g., 361 of FIG. 5B) and the second support layer (e.g., 362 of FIG. 5B).

According to an embodiment, the folding axis (e.g., FX of FIG. 5B) may extend through the third support layer (e.g., 363 of FIG. 5B).

According to an embodiment, the electronic device (e.g., 101 of FIG. 1) may comprise a digitizer (e.g., 340 of FIG. 5A) disposed between the flexible display (e.g., 322 of FIG. 5A) and the second support layer (e.g., 362 of FIG. 5B).

According to an embodiment, the electronic device (e.g., 101 of FIG. 1) may comprise a shielding layer (e.g., 350 of FIG. 5A) disposed between the digitizer (e.g., 340 of FIG. 5A) and the second support layer (e.g., 362 of FIG. 5B).

According to an embodiment, the electronic device (e.g., 101 of FIG. 1) may comprise third and fourth ground members (e.g., 383, 384 of FIG. 5B) connecting the third support layer (e.g., 363 of FIG. 5B) and the shielding layer (e.g., 350 of FIG. 5B).

According to an embodiment, the electronic device (e.g., 101 of FIG. 1) may comprise a second support plate (e.g., 374 of FIG. 5B) disposed between the third support layer (e.g., 363 of FIG. 5B) and the second support body (e.g., 372 of FIG. 5B).

According to an embodiment, the electronic device (e.g., 101 of FIG. 1) may comprise a third ground member (e.g., 583 of FIG. 7C) connecting the third support layer (e.g., 363 of FIG. 5B) and the second support plate (e.g., 374 of FIG. 5B).

According to an embodiment, the electronic device (e.g., 101 of FIG. 1) may comprise a digitizer (e.g., 340 of FIG. 5A) disposed between the flexible display (e.g., 322 of FIG. 5A) and the second support layer (e.g., 362 of FIG. 5B).

According to an embodiment, the electronic device (e.g., 101 of FIG. 1) may comprise a digitizer connection circuit (e.g., 393 of FIG. 5B) disposed between the second support layer (e.g., 362 of FIG. 5B) and the second support body (e.g., 372 of FIG. 5B) and electrically connected to the digitizer (e.g., 340 of FIG. 5A).

According to an embodiment, the electronic device (e.g., 101 of FIG. 1) may comprise a first ground member (e.g., 381 of FIG. 5B) connected to the digitizer connection circuit (e.g., 393 of FIG. 5B) and penetrating at least a portion of the second support layer (e.g., 362 of FIG. 5B).

According to an embodiment, the electronic device (e.g., 101 of FIG. 1) may comprise a second ground member (e.g., 382 of FIG. 5B) penetrating at least a portion of the second support layer (e.g., 362 of FIG. 5B) and connected to the second support body (e.g., 372 of FIG. 5B).

According to an embodiment, the electronic device (e.g., 101 of FIG. 1) may comprise a reinforcement layer (e.g., 330 of FIG. 5A) disposed between the digitizer (e.g., 340 of FIG. 5A) and the flexible display (e.g., 322 of FIG. 5A).

According to an embodiment, the electronic device (e.g., 101 of FIG. 1) may comprise a reinforcement layer (e.g., 730; 830 of FIGS. 9A to 10) disposed between the second support layer (e.g., 762; 862 of FIGS. 9A to 10) and the flexible display (e.g., 322 of FIG. 5A), and coupled to the second support layer (e.g., 762; 862 of FIGS. 9A to 10).

According to an embodiment, the electronic device (e.g., 101 of FIG. 1) may comprise a 2-1th waterproofing member (e.g., 8561 of FIG. 10) disposed between the first support layer (e.g., 861 of FIG. 10) and the first support body (e.g., 871 of FIG. 10).

According to an embodiment, the electronic device (e.g., 101 of FIG. 1) may comprise a 2-2th waterproofing member (e.g., 8562 of FIG. 10) disposed between the second support layer (e.g., 862 of FIG. 10) and the second support body (e.g., 872 of FIG. 10).

According to an embodiment, a thickness of the first support layer (e.g., 861 of FIG. 10) may be larger than a thickness of the second support layer (e.g., 862 of FIG. 10), and a thickness of the 2-1th waterproofing member (e.g., 8561 of FIG. 10) may be smaller than a thickness of the 2-2th waterproofing member (e.g., 8562 of FIG. 10).

According to an embodiment, an electronic device (e.g., 101 of FIG. 1) may comprise a flexible display (e.g., 322 of FIG. 5A), a support body (e.g., 370 of FIG. 5B) spaced apart from the flexible display (e.g., 322 of FIG. 5A), a support layer (e.g., 360 of FIG. 5B) including a conductive layer (e.g., 3611, 3621 of FIG. 5B) disposed between the flexible display (e.g., 322 of FIG. 5A) and the support body (e.g., 370 of FIG. 5B), and a reinforcement layer (e.g., 3613, 3623 of FIG. 5B) disposed between the conductive layer (e.g., 3611, 3621 of FIG. 5B) and the support body (e.g., 370 of FIG. 5B), a digitizer (e.g., 340 of FIG. 5A) disposed between the flexible display (e.g., 322 of FIG. 5A) and the support layer (e.g., 360 of FIG. 5B), a digitizer connection circuit (e.g., 393 of FIG. 5B) disposed between the support layer (e.g., 360 of FIG. 5B) and the support body (e.g., 370 of FIG. 5B), and electrically connected to the digitizer (e.g., 340 of FIG. 5A), and a ground member (e.g., 380 of FIG. 5A) connecting the digitizer connection circuit (e.g., 393 of FIG. 5B) and the conductive layer (e.g., 3611, 3621 of FIG. 5B) of the support layer (e.g., 360 of FIG. 5B), and penetrating at least a portion of the support layer (e.g., 360 of FIG. 5B).

According to an embodiment, the ground member (e.g., 380 of FIG. 5A) may include a first ground member (e.g., 381 of FIG. 5B) connecting the digitizer connection circuit (e.g., 393 of FIG. 5B) and the conductive layer (e.g., 3621 of FIG. 5B).

According to an embodiment, the ground member (e.g., 380 of FIG. 5A) may include a second ground member (e.g., 382 of FIG. 5B) connecting the conductive layer (e.g., 3621 of FIG. 5B) and the support body (e.g., 370 of FIG. 5B).

According to an embodiment, the support body (e.g., 370 of FIG. 5B) may include a first support body (e.g., 371 of FIG. 5B) spaced apart from the flexible display (e.g., 322 of FIG. 5A).

According to an embodiment, the support body (e.g., 370 of FIG. 5B) may include a second support body (e.g., 372 of FIG. 5B) spaced apart from the flexible display (e.g., 322 of FIG. 5A) and forming a folding axis (e.g., FX of FIG. 5B) between the first support body (e.g., 371 of FIG. 5B) and the second support body.

According to an embodiment, the support layer (e.g., 360 of FIG. 5B) may include a first support layer (e.g., 361 of FIG. 5B) disposed between the flexible display (e.g., 322 of FIG. 5A) and the first support body (e.g., 371 of FIG. 5B).

According to an embodiment, the support layer (e.g., 360 of FIG. 5B) may include a second support layer (e.g., 362 of FIG. 5B) disposed between the flexible display (e.g., 322 of FIG. 5A) and the second support body (e.g., 372 of FIG. 5B).

According to an embodiment, the ground member (e.g., 380 of FIG. 5A) may penetrate at least a portion of the second support layer (e.g., 362 of FIG. 5B).

According to an embodiment, the electronic device (e.g., 101 of FIG. 1) may comprise a third support layer (e.g., 363 of FIG. 5B) disposed between the first support layer (e.g., 361 of FIG. 5B) and the second support layer (e.g., 362 of FIG. 5B).

According to an embodiment, the ground member (e.g., 380 of FIG. 5A) may include a middle ground member (e.g., 384 of FIG. 5B) connected to the conductive layer (e.g., 3621 of FIG. 5B) of the second support layer (e.g., 362 of FIG. 5B).

According to an embodiment, an electronic device (e.g., 101 of FIG. 1) comprises a first housing (e.g., 210 of FIG. 4), a second housing (e.g., 220 of FIG. 4) movably coupled to the first housing (e.g., 210 of FIG. 4), a flexible display (e.g., 322 of FIG. 5A) disposed in a space formed by the first housing (e.g., 210 of FIG. 4) and the second housing (e.g., 220 of FIG. 4), a first support body (e.g., 771, 871 of FIGS. 9A to 10) spaced apart from the flexible display (e.g., 322 of FIG. 5A), a second support body (e.g., 772, 872 of FIGS. 9A to 10) spaced apart from the flexible display (e.g., 322 of FIG. 5A) and forming a folding axis (e.g., FX of FIG. 5A) between the first support body (e.g., 771, 871 of FIGS. 9A to 10) and the second support body, a first support layer (e.g., 761, 861 of FIGS. 9A to 10) disposed between the flexible display (e.g., 322 of FIG. 5A) and the first support body (e.g., 771, 871 of FIGS. 9A to 10), and a second support layer (e.g., 762, 862 of FIGS. 9A to 10) disposed between the flexible display (e.g., 322 of FIG. 5A) and the second support body (e.g., 772, 872 of FIGS. 9A to 10). The first support layer (e.g., 761, 861 of FIGS. 9A to 10) and the second support layer (e.g., 762, 862 of FIGS. 9A to 10) are spaced apart from each other with the folding axis (e.g., FX of FIG. 5A) disposed therebetween and have different thicknesses.

While the disclosure has been shown and described with reference to exemplary embodiments thereof, it will be apparent to those of ordinary skill in the art that various changes in form and detail may be made thereto without departing from the spirit and scope of the disclosure as defined by the following claims.

## Claims

1. An electronic device, comprising:
a first housing (210);
a second housing (220) movably coupled to the first housing (210);
a flexible display (322) disposed in a space formed by the first housing (210) and the second housing (220);
a first support body (371) spaced apart from the flexible display (322);
a second support body (372) spaced apart from the flexible display (322) and forming a folding axis (FX) between the first support body (371) and the second support body (372);
a first support layer (361) disposed between the flexible display (322) and the first support body (371); and
a second support layer (362) disposed between the flexible display (322) and the second support body (372),
wherein the first support layer (361) and the second support layer (362) are spaced apart from each other with the folding axis (FX) disposed therebetween, and have different thicknesses or at least partially have different materials.

2. The electronic device of claim 1, wherein the first support layer (361) includes a first reinforcement layer (3613) disposed between the flexible display (322) and the first support body (371), and the second support layer (362) includes a second reinforcement layer (3623), which is disposed between the flexible display (322) and the second support body (372) and is lighter than the first reinforcement layer (3613).

3. The electronic device of claim 1 or 2, further comprising:
a circuit board (391) disposed between the first support layer (361) and the first support body (371), and electrically connected to the flexible display (322); and
a panel bending portion (3221) forming a portion of the flexible display (322) and connected to the circuit board (391),
wherein one of the first support layer (361) and the second support layer (362) that is disposed adjacent to the panel bending portion (3221) is heavier than the other.

4. The electronic device of any one of claims 1 to 3, wherein a thickness of the first support layer (361; 761; 861) is larger than a thickness of the second support layer (362; 762; 862).

5. The electronic device of any one of claims 1 to 4, wherein the first support layer (361) includes stainless steel, and the second support layer (362) includes FR4.

6. The electronic device of any one of claims 1 to 5, wherein a folding area (S) penetrated by the folding axis (FX) is formed between the first support layer (361) and the second support layer (362).

7. The electronic device of any one of claims 1 to 6, further comprising a third support layer (363) disposed between the first support layer (361) and the second support layer (362).

8. The electronic device of claim 7, wherein the folding axis (FX) extends through the third support layer (363).

9. The electronic device of claim 7 or 8, further comprising:
a digitizer (340) disposed between the flexible display (322) and the second support layer (362);
a shielding layer (350) disposed between the digitizer (340) and the second support layer (362); and
a third ground member (383) connecting the third support layer (363) and the shielding layer (350).

10. The electronic device of any one of claims 7 to 9, further comprising:
a second support plate (374) disposed between the third support layer (363) and the second support body (372); and
a third ground member (583) connecting the third support layer (363) and the second support plate (374).

11. The electronic device of any one of claims 1 to 10, further comprising:
a digitizer (340) disposed between the flexible display (322) and the second support layer (362);
a digitizer connection circuit (393) disposed between the second support layer (362) and the second support body (372) and electrically connected to the digitizer (340); and
a first ground member (381) connected to the digitizer connection circuit (393) and penetrating at least a portion of the second support layer (362).

12. The electronic device of any one of claims 1 to 11, further comprising a second ground member (382) penetrating at least a portion of the second support layer (362) and connected to the second support body (372).

13. The electronic device of any one of claims 1 to 12, further comprising:
a digitizer (340) disposed between the flexible display (322) and the second support layer (362); and
a reinforcement layer (330) disposed between the digitizer (340) and the flexible display (322).

14. The electronic device of any one of claims 1 to 13, further comprising a reinforcement layer (730; 830) disposed between the second support layer (762; 862) and the flexible display (322), and coupled to the second support layer (762; 862).

15. The electronic device of any one of claims 1 to 14, further comprising:
a 2-1th waterproofing member (8561) disposed between the first support layer (861) and the first support body (871); and
a 2-2th waterproofing member (8562) disposed between the second support layer (862) and the second support body (872),
wherein a thickness of the first support layer (861) is larger than a thickness of the second support layer (862), and a thickness of the 2-1th waterproofing member (8561) is smaller than a thickness of the 2-2th waterproofing member (8562).
